# EUROPEAN PATENT APPLICATION

(11) **EP 4 822 380 A1**
(43) Date of publication of application: **14.10.2026**
(21) Application number: 26169359.2
(22) Date of filing: 31.03.2026
(51) Int. Cl.: G01R 33/3815

(54) **MAGNETIC RESONANCE IMAGING SYSTEM AND OPERATION METHOD OF MAGNETIC RESONANCE IMAGING SYSTEM**

(30) Priority: 11.04.2025 JP 2025065933
(71) Applicant: FUJIFILM Corporation, Tokyo 106-8620 (JP)
(72) Inventor: YOKOHAMA, Wataru, Tokyo, 1068620 (JP); KUROKAWA, Shinji, Tokyo, 1068620 (JP); INOUE, Tomoki, Tokyo, 1068620 (JP)
(74) Representative: Dehns Germany Partnerschaft mbB

(57) **Abstract**

A magnetic resonance imaging apparatus includes a superconducting magnet including a superconducting coil that is cooled to a normal temperature at which superconductivity is achieved, and a coil cooling device that cools the superconducting coil by heat conduction due to contact between a heat conduction member that is cooled via a cold head and the superconducting coil to cool the superconducting coil to the normal temperature. A processor of a magnetic resonance imaging system calculates an operable time point (excitation completion time point) at which the magnetic resonance imaging apparatus is able to start operating after demagnetization of the superconducting magnet is started based on a demagnetization start time point at which the superconducting magnet is demagnetized and a design value of the magnetic resonance imaging apparatus, displays an excitation completion time point on an operation screen 250-1 of a display, and notifies an operator of the operable time point.

## Description

### BACKGROUND OF THE INVENTION

### 1. Field of the Invention

The present invention relates to a magnetic resonance imaging system and an operation method of a magnetic resonance imaging system, and particularly relates to a technique for supporting user settings such as demagnetization start of a magnetic resonance imaging apparatus.

### 2. Description of the Related Art

A magnetic resonance imaging (MRI) apparatus in the related art includes a coil cooling device that cools a superconducting magnet (a superconducting coil included in the superconducting magnet) functioning as a magnet that generates a static magnetic field to a temperature at which superconductivity is achieved.

The coil cooling device in the related art requires liquid helium at a low temperature (4 K (Kelvin)) in order to cool the superconducting coil (for example, JP2018-068775A).

In a case of this type of MRI apparatus, in a case where the supply of the current to the superconducting coil is stopped during a period in which the MRI apparatus is not used, the current flowing through the superconducting coil changes, and the superconducting coil generates heat. However, since the liquid helium is vaporized thereby cooling the superconducting coil, the heat generation of the superconducting coil is suppressed, and a normal state is maintained. As a result, the MRI apparatus can be immediately reactivated, but there is a problem in that a large amount of valuable and expensive helium is required.

In a case where it is determined that the supply of the current to the superconducting coil of this type of MRI apparatus needs to be stopped to eliminate the magnetic field, it is essential to request the dispatch of a specialist, and the facility side incurs the effort of adjusting the standby time and the work schedule.

Therefore, in recent years, there is also an MRI apparatus that can cool the superconducting magnet without requiring liquid helium (for example, JP2013-144099A).

The MRI apparatus described in JP2013-144099A includes a coil cooling device that includes a cooling vessel that stores the superconducting coil and that is liquid helium-free, and a plurality of refrigerators that cool the superconducting coil in the cooling vessel. The refrigerator is disposed on a bobbin around which the superconducting coil is wound, and directly cools the bobbin by expanding a compressed refrigerant gas (helium gas, nitrogen gas, or the like) to generate cold heat, thereby cooling the superconducting coil disposed on the bobbin.

In a case of the MRI apparatus including the coil cooling device that does not use liquid helium, as in the MRI apparatus described in JP2013-144099A, since the refrigerator and the superconducting magnet (the bobbin around which the superconducting coil in the cooling vessel is wound) are simply connected and directly cooled, in a case where the superconducting magnet of the MRI apparatus is demagnetized from the excited state or is excited after demagnetization, the temperature of the superconducting magnet (the superconducting coil) easily rises during the demagnetization or excitation period.

Therefore, in order to prevent quenching due to the temperature increase, devices have emerged that do not use liquid helium and can automatically stop the current of the superconducting magnet (superconducting coil) and demagnetize the magnetic field, without relying on a specialized maintenance technician.

### SUMMARY OF THE INVENTION

The superconducting magnet of the MRI apparatus needs to be in a superconducting low-temperature state during imaging. On the other hand, since the MRI apparatus consumes a large amount of power (or in order to ensure safety in a high magnetic field environment or to respond to a power failure), for example, it is considered to demagnetize the magnetic field of the MRI apparatus and turn off the power supply during a period in which the MRI apparatus is not used. In this case, it is necessary to determine a timing of demagnetization according to an operator and an environment in which a facility is placed.

That is, in order to perform reactivation by excitation after demagnetization, not only a time required for controlling the current of the superconducting magnet but also a time required for cooling a temperature increase due to the current control is required, and thus the reactivation cannot be immediately performed.

It is required to perform demagnetization based on a time point at which the reactivation is required.

The present invention has been made in view of such circumstances, and an object of the present invention is to provide a magnetic resonance imaging system and an operation method of a magnetic resonance imaging system capable of supporting user settings such as a demagnetization start of a superconducting magnet.

According to a first aspect of the present invention, there is provided a magnetic resonance imaging system comprising a magnetic resonance imaging apparatus; a processor; and a user interface, in which the magnetic resonance imaging apparatus includes a superconducting magnet including a superconducting coil that is cooled to a first temperature at which superconductivity is achieved, and a coil cooling device that cools the superconducting coil by heat conduction due to contact between a heat conduction member that is cooled via a cold head and the superconducting coil to cool the superconducting coil to the first temperature, the processor is configured to acquire an operable time point at which the magnetic resonance imaging apparatus is able to start operating after demagnetization of the superconducting magnet is started based on a demagnetization start time point at which the superconducting magnet is to be demagnetized and a design value of the magnetic resonance imaging apparatus and notify an operator of the operable time point via the user interface.

According to the first aspect of the present invention, in a case in which the superconducting magnet is to be demagnetized, it is possible to notify the operator of the operable time point at which the magnetic resonance imaging apparatus can be reactivated thereafter. As a result, the operator can easily determine whether the time point at which the demagnetization of the superconducting magnet is started is appropriate for the operable time point of the magnetic resonance imaging apparatus.

According to a second aspect of the present invention, in the magnetic resonance imaging system according to the first aspect, it is preferable that the design value of the magnetic resonance imaging apparatus includes a demagnetization time from a start of the demagnetization of the superconducting magnet to completion of the demagnetization and an excitation time from a start of excitation of the superconducting magnet to completion of the excitation, and the processor is configured to acquire the operable time point obtained by adding the demagnetization time and the excitation time to the demagnetization start time point.

According to a third aspect of the present invention, in the magnetic resonance imaging system according to the second aspect, it is preferable that, in a case where demagnetization control corresponding to the demagnetization time and excitation control corresponding to the excitation time are consecutively performed and a temperature of the superconducting coil exceeds a second temperature higher than the first temperature, the design value of the magnetic resonance imaging apparatus further includes a pre-excitation waiting time from the completion of the demagnetization of the superconducting magnet to the start of the excitation of the superconducting magnet, and the processor is configured to acquire the operable time point obtained by adding the demagnetization time, the pre-excitation waiting time, and the excitation time to the demagnetization start time point.

According to the second aspect or the third aspect of the present invention, the operator can ascertain the operable time point at which the excitation is completed after the demagnetization of the superconducting magnet, with respect to the time point at which the demagnetization of the superconducting magnet is started, and thus it is possible to determine whether the demagnetization and the excitation can be completed by the start time point of the imaging by the magnetic resonance imaging apparatus.

According to a fourth aspect of the present invention, in the magnetic resonance imaging system according to the first aspect, it is preferable that the design value of the magnetic resonance imaging apparatus includes a demagnetization time from a start of the demagnetization of the superconducting magnet to completion of the demagnetization, an excitation time from a start of excitation of the superconducting magnet to completion of the excitation, and a post-excitation cooling time from the completion of the excitation of the superconducting magnet to recovery of a temperature of the superconducting coil to the first temperature, and the processor is configured to acquire the operable time point obtained by adding the demagnetization time, the excitation time, and the post-excitation cooling time to the demagnetization start time point.

As a result, the operator can ascertain the operable time point at which the excitation is completed after the demagnetization of the superconducting magnet and further the temperature of the superconducting coil is recovered to the first temperature, with respect to the time point at which the demagnetization of the superconducting magnet is started, and thus it is possible to determine whether the demagnetization and the excitation can be completed by the start time point of the imaging by the magnetic resonance imaging apparatus (start time point of the imaging under the first temperature of the superconducting coil).

According to a fifth aspect of the present invention, in the magnetic resonance imaging system according to the first aspect, it is preferable that the design value of the magnetic resonance imaging apparatus includes a demagnetization standby time from an instruction to start the demagnetization of the superconducting magnet by the operator to a start of the demagnetization of the superconducting magnet, a demagnetization time from a start of the demagnetization of the superconducting magnet to completion of the demagnetization, an excitation time from a start of excitation of the superconducting magnet to completion of the excitation, and a post-excitation cooling time from the completion of the excitation of the superconducting magnet to recovery of a temperature of the superconducting coil to the first temperature, and the processor is configured to acquire the operable time point obtained by adding the demagnetization standby time, the demagnetization time, the excitation time, and the post-excitation cooling time to the demagnetization start time point.

As a result, in a case in which there is the demagnetization standby time from the instruction to start the demagnetization of the superconducting magnet to start of the demagnetization of the superconducting magnet, the operator can ascertain the operable time point at which the excitation is completed after the demagnetization of the superconducting magnet including the demagnetization standby time and further the temperature of the superconducting coil is recovered to the first temperature, with respect to the time point at which the demagnetization of the superconducting magnet is started, and thus it is possible to determine whether the demagnetization and the excitation can be completed by the start time point of the imaging by the magnetic resonance imaging apparatus (start time point of the imaging under the first temperature of the superconducting coil).

According to a sixth aspect of the present invention, in the magnetic resonance imaging system according to any one of the first to fifth aspects, it is preferable that the processor is configured to acquire the demagnetization start time point and a demagnetization time from a start of the demagnetization of the superconducting magnet to completion of the demagnetization, acquire a demagnetization completion time point obtained by adding the demagnetization time to the demagnetization start time point, and notify the operator of the demagnetization completion time point via the user interface.

According to the sixth aspect of the present invention, in a case in which the demagnetization start instruction to demagnetize the superconducting magnet is received, it is possible to notify the operator of the demagnetization completion time point at which the demagnetization of the superconducting magnet is completed, in addition to notifying the operator of the operable time point at which the magnetic resonance imaging apparatus is able to operate next. As a result, it is possible to ascertain the period in which there is no magnetic field. For example, in a case in which it is necessary to bring a magnetic object into an examination room in which the magnetic resonance imaging apparatus is installed, the operator can ascertain the time point at which the magnetic object can be brought in.

According to a seventh aspect of the present invention, in the magnetic resonance imaging system according to any one of the first to fifth aspects, it is preferable that the magnetic resonance imaging system further comprises a memory that stores a calculation equation or a table including the design value of the magnetic resonance imaging apparatus, in which the processor is configured to acquire at least the operable time point by using the demagnetization start time point and the calculation equation or the table.

According to an eighth aspect of the present invention, in the magnetic resonance imaging system according to the seventh aspect, it is preferable that the processor is configured to predict a temperature of the superconducting coil in at least one of a case where an excitation of the superconducting magnet is completed or a case where cooling is completed after the excitation of the superconducting magnet, and notify the operator of the predicted temperature via the user interface.

According to a ninth aspect of the present invention, in the magnetic resonance imaging system according to any one of the first to eighth aspects, it is preferable that the processor is configured to receive a schedule including the demagnetization start time point and an excitation start time point of the superconducting magnet, which are set by a user, and notify the operator of the schedule via the user interface.

The operator can ascertain the schedule including the demagnetization start time point and the excitation start time point of the superconducting magnet, and at least the operable time point at which the magnetic resonance imaging apparatus can be reactivated. As a result, in a case in which the operable time point of the magnetic resonance imaging apparatus is later than the time point at which the magnetic resonance imaging apparatus is actually reactivated, the operator can adjust the schedule as appropriate to make the operable time point of the magnetic resonance imaging apparatus earlier than the actual start time point of the imaging using the magnetic resonance imaging apparatus.

According to a tenth aspect of the present invention, in the magnetic resonance imaging system according to the ninth aspect, it is preferable that the schedule includes an operation start time point of the magnetic resonance imaging apparatus, and the processor is configured to check whether the operation start time point is an earlier time point than the operable time point, and in a case where the operation start time point is an earlier time point than the operable time point, notify, via the user interface, the operator of a warning that the operation start time point is contradictory, or instruct correction of the schedule.

According to an eleventh aspect of the present invention, in the magnetic resonance imaging system according to any one of the first to tenth aspects, it is preferable that the magnetic resonance imaging system further comprises a temperature sensor that detects a temperature of the superconducting magnet or the superconducting coil, in which the processor is configured to notify the operator of a temperature at each time point detected by the temperature sensor via the user interface.

According to a twelfth aspect of the present invention, in the magnetic resonance imaging system according to any one of the first to eleventh aspects, it is preferable that the user interface includes an inquiry button for contacting a specialist of a vendor of the magnetic resonance imaging apparatus, and the processor is configured to enable contacting the specialist in a case where the inquiry button is operated, and notify the vendor of information notified to the operator via the user interface.

The information notified to the operator can be shared with the specialist of the vendor, and the specialist of the vendor can be contacted by operating the inquiry button, and advice can be received from the specialist as necessary. Even in a case in which the operation of the MRI apparatus is stopped for several days, it is possible to eliminate the need to dispatch the specialist, and it is possible to reduce the time and effort.

According to a thirteenth aspect of the present invention, in the magnetic resonance imaging system according to any one of the first to twelfth aspects, it is preferable that the user interface includes an operation button that enables automatic notification to a vendor of the magnetic resonance imaging apparatus, and the processor is configured to notify the vendor of information notified to the operator via the user interface based on an operation of the operation button.

According to a fourteenth aspect of the present invention, in the magnetic resonance imaging system according to any one of the first to thirteenth aspects, it is preferable that the processor is configured to notify a vendor of the magnetic resonance imaging apparatus of information notified to the operator via the user interface in at least one of a case where a temperature of the superconducting magnet is decreased by the coil cooling device after the demagnetization of the superconducting magnet is completed and then the temperature is increased by subsequent excitation to exceed a temperature threshold value, or a case where the excitation of the superconducting magnet is completed, the temperature of the superconducting magnet is decreased by the coil cooling device, and the temperature falls below the temperature threshold value.

According to a fifteenth aspect of the present invention, in the magnetic resonance imaging system according to the thirteenth aspect, it is preferable that the operation button is an automatic notification ON button, and the processor is configured to notify the vendor of the magnetic resonance imaging apparatus of information notified to the operator via the user interface in at least one of a case where the automatic notification ON button is turned ON and a temperature of the superconducting magnet is decreased by the coil cooling device after the demagnetization of the superconducting magnet is completed and then the temperature is increased by subsequent excitation to exceed a temperature threshold value, or a case where the automatic notification ON button is turned ON and the excitation of the superconducting magnet is completed, the temperature of the superconducting magnet is decreased by the coil cooling device, and the temperature falls below the temperature threshold value.

In a case in which the temperature of the superconducting magnet is decreased and the temperature is increased by subsequent excitation to exceed the temperature threshold value, the temperature increases due to the demagnetization is the first temperature increase, and the temperature increases due to the excitation is the second temperature increase. In a case in which the temperature of the superconducting magnet exceeds the temperature threshold value due to the second temperature increase, the recovery operation is started normally, and thus the information notified to the operator at that timing is notified to the vendor. Similarly, in a case in which the excitation of the superconducting magnet is completed, the temperature of the superconducting magnet is decreased by the coil cooling device, and the temperature falls below the temperature threshold value, the temperature decrease due to the cooling after the demagnetization is the first temperature decrease, and the temperature decrease due to the cooling after the excitation is the second temperature decrease. In a case in which the temperature of the superconducting magnet falls below the temperature threshold value due to the second temperature decrease, the superconducting magnet is heading toward complete recovery to the first temperature, and thus the information notified to the operator at that timing is notified to the vendor.

According to a sixteenth aspect of the present invention, in the magnetic resonance imaging system according to the thirteenth aspect, it is preferable that the operation button is a save button for saving a schedule including the demagnetization start time point and an excitation start time point of the superconducting magnet, which are set by a user, and the user interface is configured to, in a case where the save button is operated, save the schedule in a memory and notify the vendor of the magnetic resonance imaging apparatus of information notified to the operator via the user interface.

According to a seventeenth aspect of the present invention, there is provided an operation method of a magnetic resonance imaging system including a magnetic resonance imaging apparatus, a processor, and a user interface, in which the magnetic resonance imaging apparatus includes a superconducting magnet including a superconducting coil that is cooled to a first temperature at which superconductivity is achieved, and a coil cooling device that cools the superconducting coil by heat conduction due to contact between a heat conduction member that is cooled via a cold head and the superconducting coil to cool the superconducting coil to the first temperature, the operation method comprising acquiring, by the processor, an operable time point at which the magnetic resonance imaging apparatus is able to start operating after demagnetization of the superconducting magnet is started based on a demagnetization start time point at which the superconducting magnet is to be demagnetized and a design value of the magnetic resonance imaging apparatus, and notifying, by the processor, an operator of the operable time point via the user interface.

According to an eighteenth aspect of the present invention, in the operation method of the magnetic resonance imaging system according to the seventeenth aspect, it is preferable that the operation method further comprises acquiring, by the processor, the demagnetization start time point and a demagnetization time from a start of the demagnetization of the superconducting magnet to completion of the demagnetization, acquiring, by the processor, a demagnetization completion time point obtained by adding the demagnetization time to the demagnetization start time point, and notifying, by the processor, the operator of the demagnetization completion time point via the user interface.

According to the present invention, the operable time point at which the magnetic resonance imaging apparatus can be reactivated thereafter can be acquired based on the demagnetization start time point at which the superconducting magnet is demagnetized, and the operator can be notified of the operable time point, thereby supporting the user setting such as the demagnetization start of the superconducting magnet.

### BRIEF DESCRIPTION OF THE DRAWINGS

FIG. 1 is a perspective view showing an appearance of a magnetic resonance imaging apparatus (MRI apparatus) applied to a magnetic resonance imaging system according to the present invention.
FIG. 2 is a diagram showing a schematic configuration of an inside of a magnetic resonance imaging system according to the present invention.
FIG. 3 is a diagram showing a cross-sectional structure of a magnet of the MRI apparatus shown in FIG. 1.
FIG. 4 is a view showing a state inside an operation room in which the MRI apparatus is operated.
FIG. 5 is a diagram showing a first embodiment of the magnetic resonance imaging system according to the present invention, and particularly, is a diagram showing an operation screen of a display.
FIG. 6 is a timing chart used to describe a calculation method of a first pattern.
FIG. 7 is a timing chart used to describe a calculation method of a second pattern.
FIG. 8 is a diagram showing a second embodiment of the magnetic resonance imaging system according to the present invention, and particularly, is a diagram showing an operation screen of a display.
FIG. 9 is a timing chart showing a state of each part of the MRI apparatus in the second embodiment of the magnetic resonance imaging system according to the present invention.
FIG. 10 is a timing chart used to describe definitions of each time point and a time in a calculation method of the time point.
FIG. 11 is a diagram showing an example of a temperature change curve in a case where cooling is performed from a critical temperature Tc.
FIG. 12 is a diagram showing a function Δf(temp0, Δtime) that gives a temperature change after a time Δtime has elapsed from an initial temperature temp0.
FIG. 13 is a timing chart showing a state of each part of the MRI apparatus in a third embodiment of the magnetic resonance imaging system according to the present invention.
FIG. 14 is a diagram showing the third embodiment of the magnetic resonance imaging system according to the present invention, and particularly, is a diagram showing an operation screen of a display.
FIG. 15 is a timing chart showing a state of each part of the MRI apparatus in a fourth embodiment of the magnetic resonance imaging system according to the present invention.
FIG. 16 is a schematic diagram showing a fifth embodiment of the magnetic resonance imaging system according to the present invention.
FIG. 17 is a graph showing an example of a change in a coil temperature associated with time control of demagnetization/excitation.
FIG. 18 is a flowchart showing an embodiment of an operation method of the magnetic resonance imaging system according to the embodiment of the present invention.

### DESCRIPTION OF THE PREFERRED EMBODIMENTS

Hereinafter, preferred embodiments of a magnetic resonance imaging system and an operation method of a magnetic resonance imaging system according to the present invention will be described with reference to the accompanying drawings.

### Appearance of MRI Apparatus

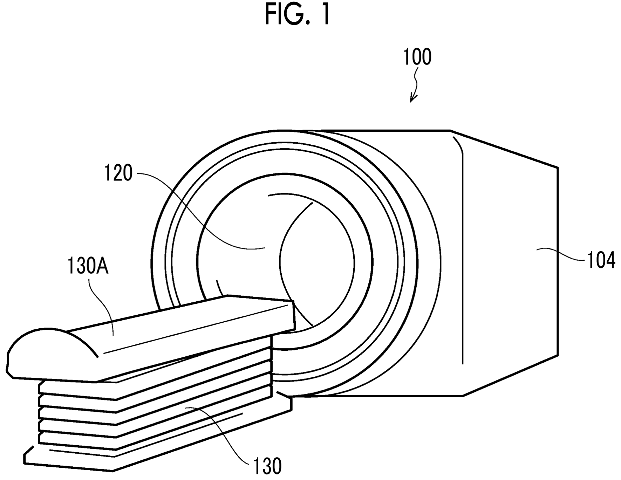

FIG. 1 is a perspective view showing an appearance of a magnetic resonance imaging apparatus (MRI apparatus) applied to a magnetic resonance imaging system according to the present invention.

An MRI apparatus 100 shown in FIG. 1 comprises a magnet 104 that generates a static magnetic field, and a patient table 130 comprising a tabletop 130A disposed on a front side of a cylindrical imaging space 120 provided in the magnet 104.

### Internal Configuration of Magnetic Resonance Imaging System

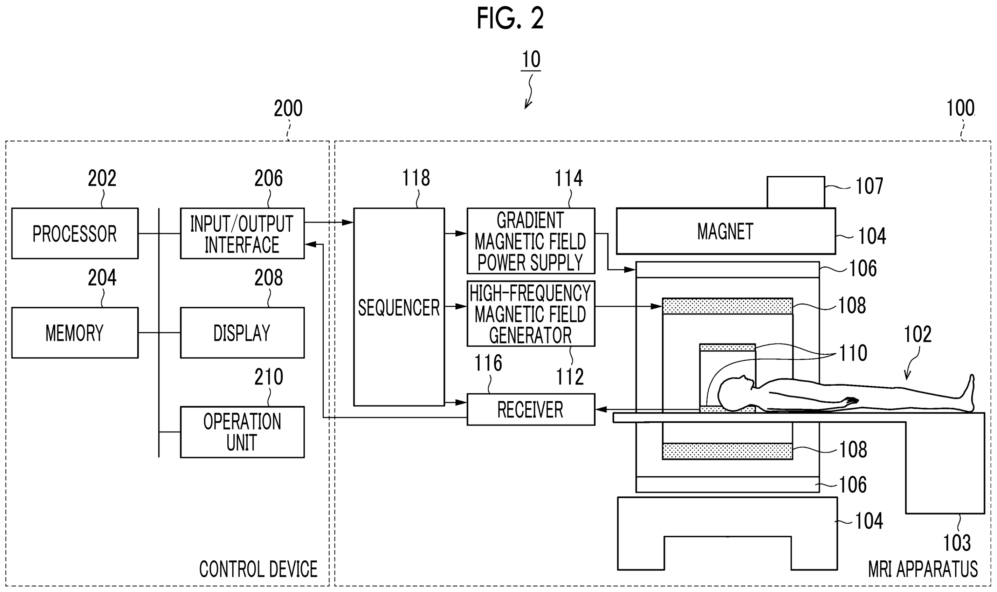

FIG. 2 is a diagram showing a schematic configuration of an inside of a magnetic resonance imaging system according to the present invention.

As shown in FIG. 2, a magnetic resonance imaging system 10 comprises an MRI apparatus 100 and a control device 200.

### MRI Apparatus

The MRI apparatus 100 comprises a magnet 104 that generates a uniform static magnetic field in an imaging space 120 in which a subject 102 is disposed, a gradient magnetic field coil 106 that generates a gradient magnetic field in the imaging space 120, a radio frequency (RF) coil (transmit coil) 108 that generates a high-frequency magnetic field that causes a nuclear magnetic resonance signal (NMR signal) to be generated in an atomic nucleus of an atom constituting a tissue of the subject 102, and a receive coil 110 that detects the NMR signal generated by the subject 102.

The subject 102 is usually disposed in the imaging space 120 in a state of lying on the tabletop 130A of the patient table 130. A receive coil 110 corresponding to an examination site of the subject 102 is used, and is installed on the subject 102 on the patient table 130.

A sequencer 118 transmits control information to a high-frequency magnetic field generator 112 and a gradient magnetic field power supply 114 in accordance with an imaging sequence, and controls acquisition of the NMR signal by a receiver 116.

The high-frequency magnetic field generator 112 generates a high-frequency current pulse of a Larmor frequency that causes nuclear magnetic resonance based on the control information input from the sequencer 118, and transmits the high-frequency current pulse to the transmit coil 108. An RF pulse corresponding to the high-frequency current pulse is transmitted from the transmit coil 108 to the subject 102.

The receive coil 110 detects the NMR signal generated in a case where the nuclear spins in the subject 102 are excited by the RF pulse, amplifies the detected NMR signal, and transmits the amplified NMR signal to a control device 200 via the receiver 116. The NMR signal is usually generated by a gradient echo or a spin echo and an imaging sequence (pulse sequence), and the generated signal is referred to as an echo signal.

The receive coil 110 shown in FIG. 1 receives the echo signal from the head of the subject 102, but is not limited to receiving the echo signal from the head, and a receive coil corresponding to an examination site such as the chest, the abdomen, the lumbar region, the shoulder, and the hand and foot of the subject 102 is used and is appropriately set. In addition, the receive coil also includes a flexible blanket type receive coil that is placed over the chest, the abdomen, and the lumbar region.

The gradient magnetic field coil 106 is composed of an X-axis gradient magnetic field coil, a Y-axis gradient magnetic field coil, and a Z-axis gradient magnetic field coil that generate gradient magnetic fields Gx, Gy, and Gz in the X-axis direction, the Y-axis direction, and the Z-axis direction of the imaging space 120, respectively, and generates a gradient magnetic field corresponding to a current supplied from the gradient magnetic field power supply 114 in the imaging space 120.

The sequencer 118 controls each part to operate at a timing and intensity programmed in advance. Among the programs, a program that particularly describes the RF pulse, the gradient magnetic fields Gx, Gy, and Gz, and the timing and intensity of signal reception is called an imaging sequence (pulse sequence).

Various pulse sequences are known depending on the purpose, but detailed descriptions thereof will be omitted here.

### Magnet and Coil Cooling Device

The magnet 104 that generates the static magnetic field may be a magnet that generates the static magnetic field in the vertical direction or a magnet that generates the static magnetic field in the horizontal direction, but the magnet that generates the static magnetic field in the horizontal direction will be described as an example.

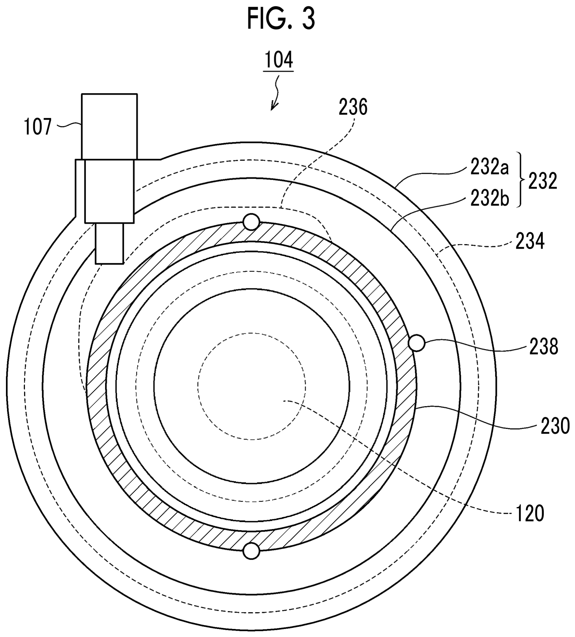

FIG. 3 is a diagram showing a cross-sectional structure of a magnet 104 of the MRI apparatus shown in FIG. 1.

As shown in FIG. 3, the magnet 104 generates the static magnetic field in the horizontal direction (body axis direction of the subject 102) by using a superconducting coil 230 in which a coil is wound in a cylindrical shape. The superconducting coil 230 wound in a cylindrical shape is disposed in a cylindrical vacuum vessel 232.

The vacuum vessel 232 has a double structure of an outer vessel 232a and an inner vessel 232b. A space between the outer vessel 232a and the inner vessel 232b is evacuated to a predetermined pressure, and a radiation heat shield plate 234 is disposed. The superconducting coil 230 is disposed in the inner vessel 232b.

A space in which the superconducting coil 230 is disposed in the inner vessel 232b is evacuated to a predetermined pressure. The imaging space 120 in which the subject 102 is disposed is formed in a space near a central axis of the vacuum vessel 232.

The vacuum vessel 232 is provided with a cold head 107 and a distal end of the cold head 107 is inserted into the inner vessel 232b of the vacuum vessel 232. A compressor (not shown) is connected to the cold head 107, and a refrigerant gas compressed by the compressor is supplied to the cold head 107. The cold head 107, the compressor, and the like constitute a coil cooling device (cryocooler) that cools the superconducting coil 230 (magnet 104).

The refrigerant gas is adiabatically expanded inside the cold head 107 to generate a cooling effect, and the distal end of the cold head 107 is cooled. A heat conduction member 236 having high thermal conductivity is disposed between the distal end of the cold head 107 and the superconducting coil 230, and one end of the heat conduction member 236 is connected to the cold head 107 and the other end is connected to the superconducting coil 230, respectively. As a result, the coil cooling device cools the superconducting coil 230 to a normal temperature (hereinafter, referred to as a "normal temperature") such as a first temperature (for example, 4 K) at which superconductivity is achieved, by heat conduction due to contact between the heat conduction member 236 cooled via the cold head 107 and the superconducting coil 230.

In addition, a part of the cold head 107 is connected to the radiation heat shield plate 234 of the vacuum vessel 232 and the inner vessel 232b, and cools the radiation heat shield plate 234 and the inner vessel 232b.

In this way, the coil cooling device maintains the thermal equilibrium state of the magnet 104 and realizes a closed-type superconducting magnet. That is, the cooling capacity is controlled such that the amount of heat entering the vacuum vessel 232 is cooled without excess or deficiency.

In addition, a plurality of temperature sensors 238 for monitoring the operating state of the magnet 104 are incorporated into the magnet 104.

The vacuum vessel 232, which is a cooling vessel, is in a reduced-helium state. Here, the reduced-helium state means a state in which liquid helium and gas helium are not present in the cooling vessel, a state in which gas helium is present but liquid helium is not present, or a state in which the superconducting coil 230 is cooled by heat conduction from a heat conduction member 236 that is in contact with the cold head 107, such that helium does not contact the superconducting coil 230, and liquid helium and/or gas helium are present in the cooling vessel.

That is, the MRI apparatus 100 to which the present invention is applied comprises a reduced-helium coil cooling device.

In addition, in a case of the reduced-helium coil cooling device, since liquid helium is not present in the cooling vessel, when the magnet 104 of the MRI apparatus 100 is demagnetized from the excited state or is excited after the demagnetization, the superconducting coil 230 generates heat beyond the cooling capacity of the reduced-helium coil cooling device in accordance with a change in the coil current flowing through the superconducting coil 230 during the demagnetization period or the excitation period. Therefore, the temperature of the superconducting coil 230 (magnet 104) easily rises from the normal temperature of superconductivity.

That is, the magnet 104 including the superconducting coil of the MRI apparatus 100 is cooled by the reduced-helium coil cooling device, but the temperature of the superconducting coil 230 rises from the normal temperature of superconductivity in accordance with a change in the coil current during the demagnetization period and the excitation period of the magnet 104.

### Control Device

The control device 200 comprises a processor 202, a memory 204, an input/output interface 206, a display 208, and an operation unit 210 as hardware.

The processor 202 includes a central processing unit (CPU), integrally controls each unit in the control device 200, controls the operation of the MRI apparatus 100 via the sequencer 118, receives digital data (measurement data) of the echo signal via the receiver 116, and performs various types of signal processing such as image reconstruction.

In addition, the processor 202 receives a demagnetization start instruction to demagnetize the magnet 104 of the MRI apparatus 100, and starts the demagnetization of the magnet 104 of the MRI apparatus 100 in a case where a demagnetization start time point is reached, receives an excitation start instruction to excite the magnet 104, and starts the excitation of the magnet 104 in a case where an excitation start time point is reached.

Further, in a case where the demagnetization start instruction is received, the processor 202 can notify of an operable time point at which the MRI apparatus 100 is able to start operating next after the demagnetization of the MRI apparatus 100 is started, and also notify of a demagnetization completion time point at which the demagnetization of the MRI apparatus 100 is completed, thereby supporting the user setting of the demagnetization start and the excitation start of the MRI apparatus 100. Details of the processing of supporting the user setting of the demagnetization start and the excitation start will be described below.

The memory 204 includes a flash memory, a read-only memory (ROM), a random-access memory (RAM), a hard disk apparatus, and the like. The flash memory, the ROM, or the hard disk apparatus is a non-volatile memory that stores an operating system, a program for causing the processor 202 to function as the control device 200 of the MRI apparatus 100, a calculation equation or a table necessary for calculating the demagnetization completion time point, the excitation completion time point, and the cooling completion time point of the magnet 104 described below, a design value of the MRI apparatus 100, and the like.

The RAM functions as a work area for processing by the processor 202 and temporarily stores the programs and the like stored in the non-volatile memory. The processor 202 may incorporate a part (RAM) of the memory 204.

The input/output interface 206 includes a communication unit that can be connected to a network, a connection unit that can be connected to an external apparatus, and the like. For example, a universal serial bus (USB), a high-definition multimedia interface (HDMI) (HDMI is a registered trademark), or the like can be applied as the connection unit that can be connected to the external apparatus.

The processor 202 communicates with the apparatus (in the present example, the sequencer 118 and the receiver 116) provided in the MRI apparatus 100 via the input/output interface 206 to transmit and receive necessary information. A part of the sequencer 118 may be provided on a control device 200 side.

The display 208 is used as a part of a user interface that displays an MRI image and an operation screen or the like in a case of receiving an input from the operation unit 210, and in the manual setting of the schedule including the demagnetization start and the excitation start of the MRI apparatus 100, in a case where there is a contradiction between the time points of demagnetization completion and excitation completion of the MRI apparatus 100 and the schedule, the display 208 notifies the operator of a warning or instructs the operator to correct the schedule.

The operation unit 210 includes a mouse, a keyboard, and the like, and functions as a part of a user interface that uses an operation screen of the display 208 to receive an input from the operator.

### Embodiment of Magnetic Resonance Imaging System

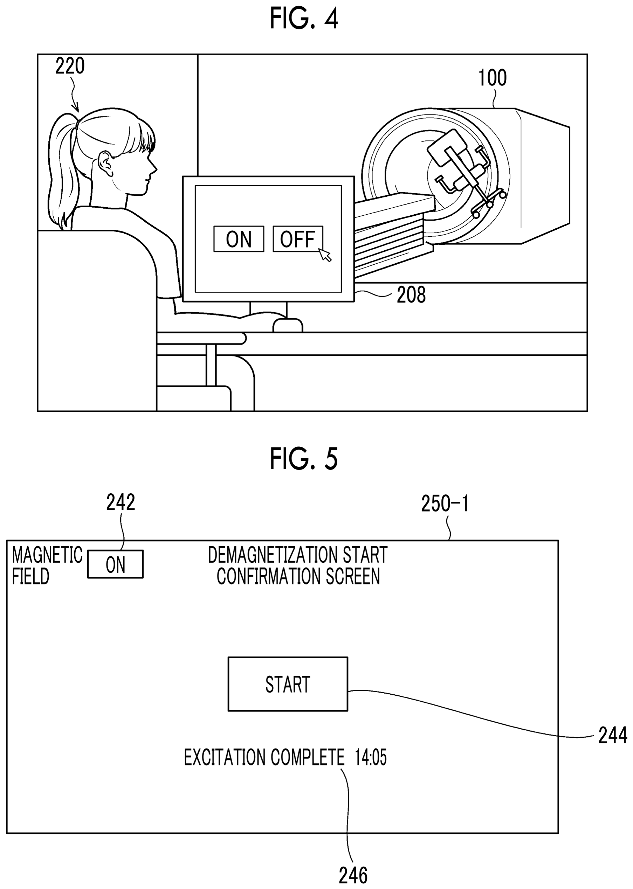

FIG. 4 is a view showing a state inside an operation room in which the MRI apparatus is operated.

As shown in FIG. 4, the operation room is provided with the control device 200 (see FIG. 2) that controls the MRI apparatus 100 installed in the examination room, processes the echo signal output from the MRI apparatus 100, and generates the MRI image.

An operator 220 can control the operation of the MRI apparatus 100 through the control device 200 by using the operation unit 210 (see FIG. 2) such as a keyboard and a mouse and the display 208.

In FIG. 4, the operation room is provided with a window for the operator 220 to view the inside of the examination room.

### First Embodiment

FIG. 5 is a diagram showing a first embodiment of the magnetic resonance imaging system according to the present invention, and particularly, is a diagram showing an operation screen of a display.

In a case where the operator 220 starts the demagnetization of the magnet 104 of the MRI apparatus 100, the operator 220 wants to check the operable time point (for example, the excitation completion time point in a case where the magnet 104 is excited again after the demagnetization is completed) at which the MRI apparatus 100 can start to operate next.

An operation screen 250-1 shown in FIG. 5 is a screen for checking the excitation completion time point at which the excitation is completed next in a case where the demagnetization of the magnet 104 is started, and can be displayed, for example, by operating an "OFF" button for demagnetizing the magnet 104 on the operation screen of the display 208 shown in FIG. 4.

The operation screen 250-1 shown in FIG. 5 is provided with a display field 242 showing a current situation (magnetic field ON/OFF) of the magnetic field of the MRI apparatus 100, a "START" button 244 for starting the demagnetization, and a display field 246 for displaying the operable time point (in this example, the excitation completion time point) at which the MRI apparatus 100 can start to operate next in a case where the demagnetization is started.

The processor 202 acquires, by adding the demagnetization time and the excitation time to the demagnetization start time point, the operable time point (for example, the excitation completion time point) at which the MRI apparatus 100 can start to operate next after the demagnetization is started and displays the acquired excitation completion time point in the display field 246 of the operation screen 250-1.

The demagnetization time and the excitation time can be stored in the memory 204 in advance as design values of the MRI apparatus 100, and the processor 202 can read out the demagnetization time and the excitation time from the memory 204 and use the demagnetization time and the excitation time as necessary.

In addition, the user operation start time point before the "START" button 244 is operated is the current time point, which changes from moment to moment. The excitation completion time point is acquired by the processor 202 based on the user operation start time point that changes from moment to moment, and is displayed in the display field 246. The display field 246 may be updated and displayed in units of seconds, or may be updated and displayed at regular time intervals such as several minutes. In addition, in a case where the "START" button 244 is operated, the operation time point is fixed as the user operation start time point, and the time point at which the excitation of the MRI apparatus 100 is completed is displayed in the display field 246.

### Calculation Method of Excitation Completion Time Point

Next, a calculation method of the excitation completion time point will be described.

There are two calculation methods of the excitation completion time point, that is, a first pattern and a second pattern.

(Calculation Method of First Pattern)

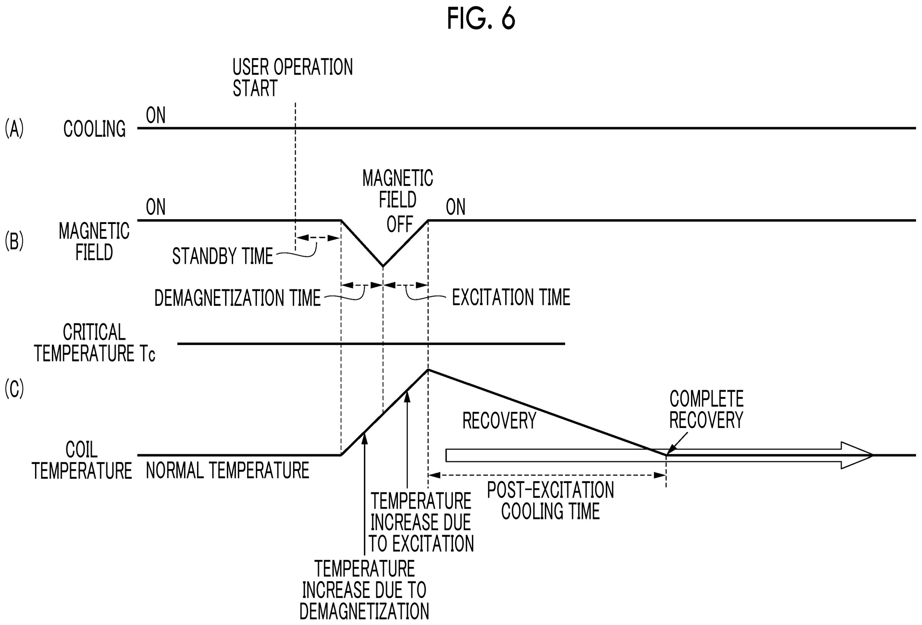

The calculation method of the first pattern is a calculation method corresponding to a case where the excitation can be performed immediately after the demagnetization, and FIG. 6 is a timing chart used to describe the calculation method of the first pattern.

As shown in FIG. 6, the calculation method of the first pattern is a calculation method in a case where the temperature of the superconducting coil does not exceed a second temperature (in the present example, the critical temperature Tc) higher than a normal temperature (first temperature) even in a case where the excitation is performed immediately after the demagnetization, and each time point and the temperature can be obtained by the following calculation equation. 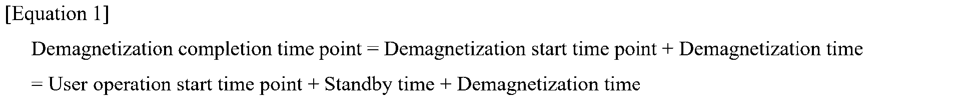[Equation 1] Demagnetization completion time point = Demagnetization start time point + Demagnetization time = User operation start time point + Standby time + Demagnetization time [Equation 2] $Excitation completion time point = Demagnetization completion time point + Excitation time$ [Equation 3] 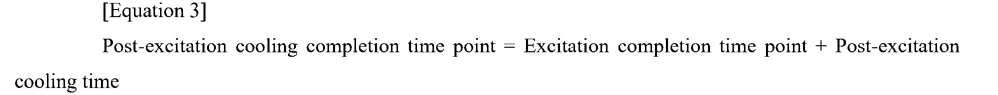 Post-excitation cooling completion time point = Excitation completion time point + Post-excitation cooling time [Equation 4] 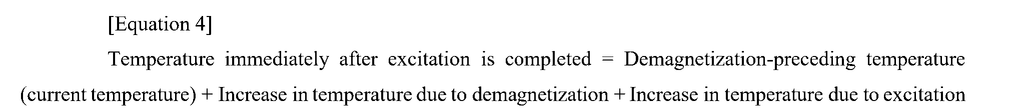 Temperature immediately after excitation is completed = Demagnetization-preceding temperature (current temperature) + Increase in temperature due to demagnetization + Increase in temperature due to excitation [Equation 5] 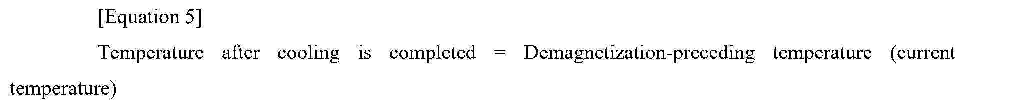 Temperature after cooling is completed = Demagnetization-preceding temperature (current temperature)

### Calculation Method of Second Pattern

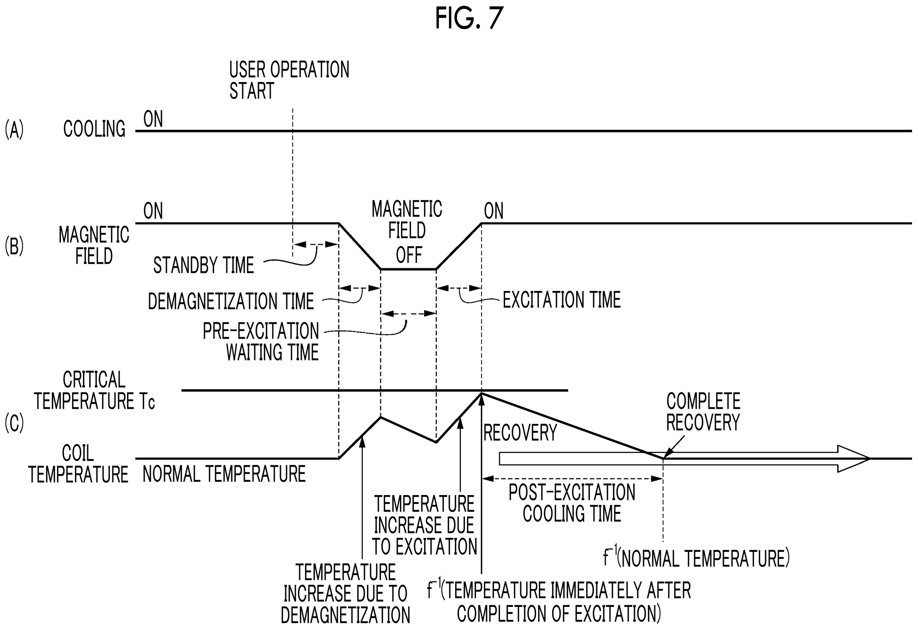

The calculation method of the second pattern is a calculation method corresponding to a case where the temperature of the superconducting coil exceeds the critical temperature Tc (that is, a case where the pre-excitation waiting time occurs after the demagnetization such that the temperature does not exceed the critical temperature Tc) in a case where the demagnetization control corresponding to the demagnetization time and the excitation control corresponding to the excitation time are consecutively performed, and FIG. 7 is a timing chart used to describe the calculation method of the second pattern.

In a case where the excitation is performed immediately after the demagnetization, the temperature of the magnet 104 (superconducting coil) may exceed the critical temperature Tc because the temperature increase due to the demagnetization and the temperature increase due to the excitation are added. In this case, as shown in (C) OF FIG. 7, a time (that is, pre-excitation waiting time until the excitation is started) for turning off the magnetic field as shown in (B) of FIG. 7 is required between the completion of the demagnetization and the start of the excitation such that the temperature of the superconducting coil does not exceed the critical temperature Tc.

The calculation method of the second pattern is a calculation method in a case where the pre-excitation waiting time occurs, and each time point and the temperature can be obtained by the following calculation equations. [Equation 1] 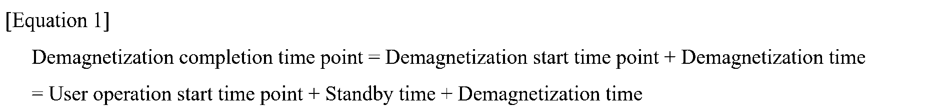 Demagnetization completion time point = Demagnetization start time point + Demagnetization time = User operation start time point + Standby time + Demagnetization time [Equation 2] 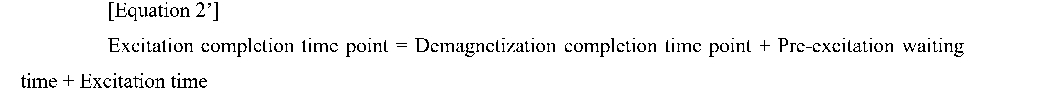 [Equation 2'] Excitation completion time point = Demagnetization completion time point + Pre-excitation waiting time + Excitation time [Equation 3] 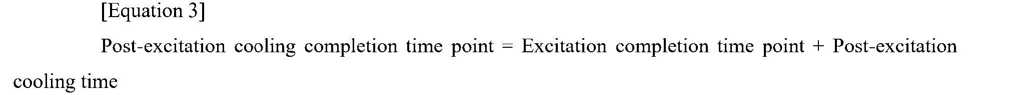 Post-excitation cooling completion time point = Excitation completion time point + Post-excitation cooling time [Equation 4] $Temperature immediately after excitation is completed = Critical temperature Tc$ [Equation 5] 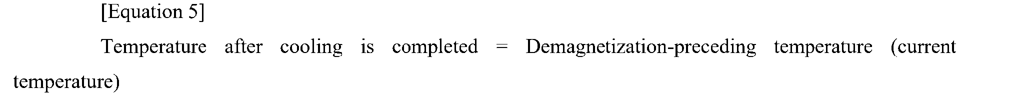 Temperature after cooling is completed = Demagnetization-preceding temperature (current temperature)

Here, the pre-excitation waiting time in [Equation 2'] is obtained as a solution to the following equation. [Equation 6] 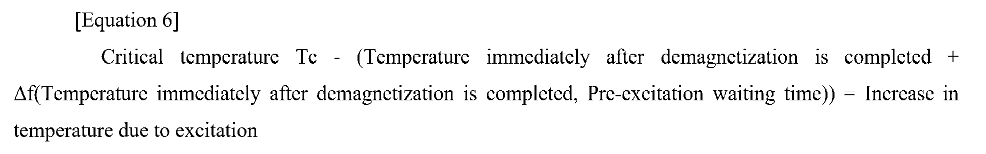 Critical temperature Tc - (Temperature immediately after demagnetization is completed + Δf(Temperature immediately after demagnetization is completed, Pre-excitation waiting time)) = Increase in temperature due to excitation

In addition, the post-excitation cooling time in [Equation 3] is a solution to the following equation. [Equation 7] 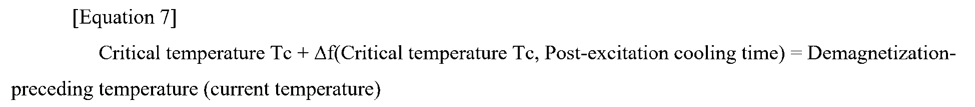 Critical temperature Tc + Δf(Critical temperature Tc, Post-excitation cooling time) = Demagnetization-preceding temperature (current temperature)

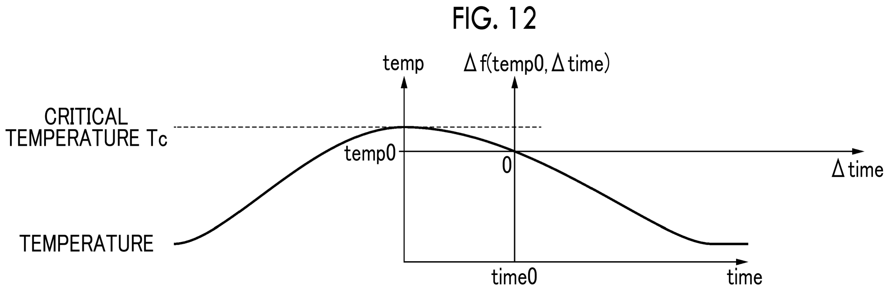

Here, Δf is a function having an initial temperature (temp0) and a cooling time (time) as parameters, which indicates a temperature change in a case where the temperature of the superconducting coil decreases from a certain initial temperature temp0 toward a normal temperature by the coil cooling device as shown in FIG. 12 described below while the heat generation of the superconducting coil is stopped.

The definitions of each time point and time in [Equation 1] to [Equation 5] are as follows.
· Demagnetization start time point: Time point at which the actual demagnetization is started (time point obtained by adding the demagnetization standby time to the user operation start time point, or user operation start time point in a case where there is no demagnetization standby time)
· User operation start time point: Time point at which the user instructs the demagnetization using a demagnetization start button or the like
· Demagnetization standby time: Preparation time for the demagnetization of the MRI apparatus 100
· Demagnetization time: Time taken from a state in which the magnetic field (static magnetic field) is present (ON) to a state in which the magnetic field is absent (OFF)
· Pre-excitation waiting time: Time from the completion of the demagnetization to the start of the excitation
· Demagnetization completion time point: Time point at which the magnetic field (static magnetic field) becomes absent
· Excitation time: Time taken from a state in which the magnetic field (static magnetic field) is absent (OFF) to a state in which the magnetic field is present (ON)
· Post-excitation cooling time: Time taken from the temperature increase due to the excitation to the return to the normal temperature by the cooling

According to the first embodiment, in a case of the MRI apparatus corresponding to the first pattern, the operable time point (excitation completion time point) obtained by adding the demagnetization time and the excitation time to the demagnetization start time point can be acquired, and the excitation completion time point can be displayed in the display field 246 of the operation screen 250-1, and in a case of the MRI apparatus corresponding to the second pattern, the operable time point (excitation completion time point) obtained by adding the demagnetization time, the pre-excitation waiting time, and the excitation time to the demagnetization start time point can be acquired, and the excitation completion time point can be displayed in the display field 246 of the operation screen 250-1.

The post-excitation cooling completion time point may be displayed on the operation screen 250-1 instead of the excitation completion time point, or the excitation completion time point and the post-excitation cooling completion time point may be displayed on the operation screen 250-1. The post-excitation cooling completion time point can be calculated by adding the post-excitation cooling time to the excitation completion time point.

In addition, in a case of the MRI apparatus corresponding to the first pattern, the processor 202 can obtain the temperature immediately after the excitation is completed and the temperature after the completion of the cooling after the excitation by using the above-described [Equation 4] and [Equation 5], respectively, and can display the temperatures on the display 208, and in a case of the MRI apparatus corresponding to the second pattern, the processor 202 can obtain the temperature immediately after the excitation is completed and the temperature after the completion of the cooling after the excitation by using the above-described [Equation 4'] and [Equation 5], respectively, and can display the temperatures on the display 208.

### Second Embodiment

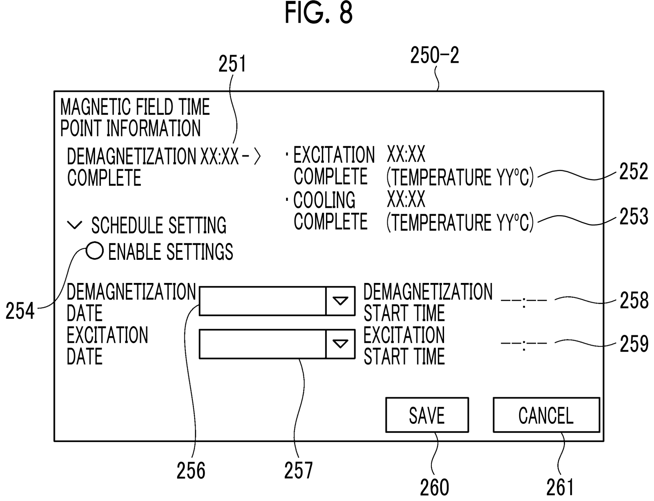

FIG. 8 is a diagram showing a second embodiment of the magnetic resonance imaging system according to the present invention, and particularly, is a diagram showing an operation screen of a display.

The staff of the hospital has a request to turn off the magnetic field of the MRI apparatus 100 in a case where the magnetic object is inevitably brought into the examination room.

Therefore, in a case where the processor 202 of the control device 200 receives the demagnetization start time point from the operator 220 by using the operation screen 250-2 of the display 208 shown in FIG. 8, the processor 202 starts the demagnetization of the magnet 104 of the MRI apparatus 100 from the demagnetization start time point, calculates the time point at which the demagnetization of the magnet 104 is completed, and displays the demagnetization completion time point on the operation screen 250-2.

As a result, the operator 220 can check the time slot in which the magnetic object can be safely brought into the examination room.

In FIG. 8, reference numeral 251 is a display field in which the demagnetization completion time point at which the demagnetization is completed is displayed, and reference numerals 252 and 253 are display fields in which the excitation completion time point (with a predicted temperature) at which the excitation is completed and the cooling completion time point (with a predicted temperature) at which the cooling to the normal temperature is performed after the excitation are displayed, respectively.

It is preferable to perform the imaging by the MRI apparatus 100 after the complete recovery in which the magnet 104 is cooled to the normal temperature, but since the imaging can be performed once excitation is completed, the time points of both the excitation completion time point and the cooling completion time point can be understood in the display field 252 and the display field 253.

In addition, reference numeral 254 is a "radio button" for enabling the setting of the excitation start date and time and the demagnetization start date and time, and reference numerals 256 and 257 are "list boxes" for setting the demagnetization start date and the excitation start date, respectively. Further, reference numerals 258 and 259 are "input fields" for receiving the input of the demagnetization start time (time point) on the demagnetization start date and the excitation start time (time point) on the excitation start date, respectively.

In addition, the demagnetization start date and time and the excitation start date and time are set by the user using the operation screen 250-2. Reference numeral 260 is a "save button" used in a case of saving the schedule set by the user, and reference numeral 261 is a "cancel button" for canceling the saved schedule.

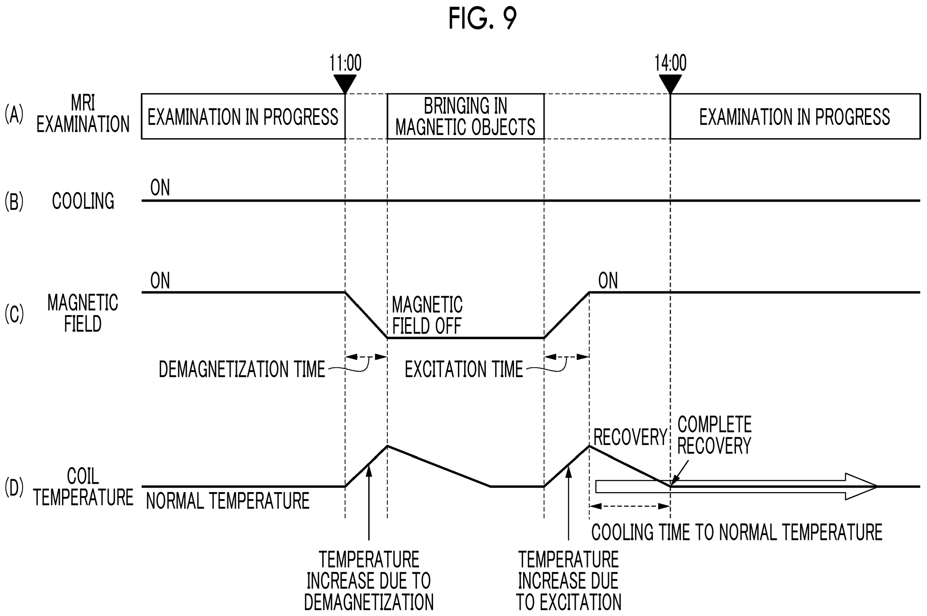

FIG. 9 is a timing chart showing the state of each part of the MRI apparatus in the second embodiment of the magnetic resonance imaging system according to the present invention.

(A) of FIG. 9 is a timing chart showing the state of the MRI examination by the MRI apparatus 100, and shows an examination-in-progress period (examination available period) and the period during which the magnetic object can be brought in.

As shown in (B) of FIG. 9, the coil cooling device of the MRI apparatus 100 is always in the ON state.

As shown in (C) of FIG. 9, during examination-in-progress period by the MRI apparatus 100 (examination available period), the magnetic field of the magnet 104 is turned ON, and the magnetic field of the magnet 104 in the period during which the magnetic object can be brought in is turned OFF.

In the example shown in FIG. 9, the demagnetization is started at 11:00, and the magnetic field in the ON state gradually decreases from 11:00 and becomes the magnetic field OFF.

(D) of FIG. 9 is a diagram showing a change in the coil temperature of the superconducting coil 230 included in the magnet 104 over time.

As shown in (D) of FIG. 9, the coil temperature, which is the normal temperature, increases due to the demagnetization from 11:00 when the demagnetization is started. This is because the current flowing through the superconducting coil 230 changes due to the demagnetization, and the superconducting coil 230 generates heat beyond the cooling capacity per unit time by the coil cooling device.

In a case in which the demagnetization of the magnet 104 is completed (in a case in which the excitation is turned OFF), the magnetic object can be brought in.

In the second embodiment, the processor 202 calculates a demagnetization completion time point at which the demagnetization of the magnet 104 is completed, and displays the demagnetization completion time point in the display field 251 of the operation screen 250-2. As a result, the operator 220 can ascertain the demagnetization completion time point.

In a case in which the demagnetization of the magnet 104 is completed, the current flowing through the superconducting coil 230 becomes zero, and the heat generation of the superconducting coil is stopped. On the other hand, since the coil cooling device is always turned ON, the temperature of the superconducting coil 230 (magnet 104) that has increased due to the demagnetization gradually decreases and is recovered to the normal temperature.

In a case in which the bringing-in of the magnetic object into the examination room is completed, the magnetic object brought into the examination room is removed, and the examination by the MRI apparatus 100 is started, the processor 202 starts the excitation of the magnet 104 in response to an instruction to start the excitation.

In a case in which the excitation of the magnet 104 is started (in a case in which the current is caused to flow through the superconducting coil 230), the coil temperature that has decreased to the normal temperature increases due to the excitation. This is because the current flowing through the superconducting coil 230 changes due to the excitation, and the superconducting coil 230 generates heat beyond the cooling capacity per unit time by the coil cooling device.

In a case in which the excitation of the magnet 104 is completed (in a case in which the excitation is turned ON), the current flowing through the superconducting coil 230 becomes a constant current, and the heat generation of the superconducting coil 230 is stopped. On the other hand, since the coil cooling device is always turned ON, the temperature of the superconducting coil 230 (magnet 104) that has increased due to the excitation gradually decreases and is recovered to the normal temperature.

The processor 202 predicts an excitation completion time point of the magnet 104, displays the excitation completion time point in the display field 252 of the operation screen 250-2, and predicts a cooling completion time point at which the temperature is recovered to the normal temperature after the excitation is completed, and displays the cooling completion time point in the display field 253 of the operation screen 250-2.

In addition, the processor 202 predicts the coil temperatures at the excitation completion time point and the cooling completion time point, and displays the coil temperatures in the display fields 252 and 253, respectively.

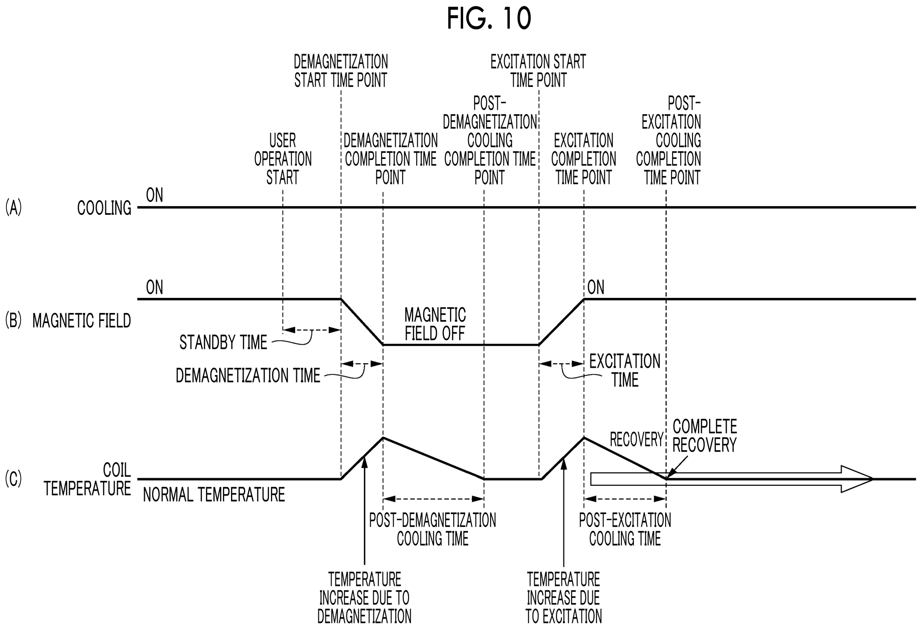

FIG. 10 is a timing chart used to describe definitions of each time point and a time in a calculation method of the time point.

As shown in FIG. 10, the definition of each time point and time in the calculation method of the time point is as follows.

· Demagnetization start time point: Time point at which the actual demagnetization is started (time point obtained by adding the demagnetization standby time to the user operation start time point, or user operation start time point in a case where there is no demagnetization standby time)
· User operation start time point: Time point at which the user instructs the demagnetization using a demagnetization start button or the like
· Demagnetization standby time: Preparation time for the demagnetization of the MRI apparatus 100
· Demagnetization time: Time taken from a state in which the magnetic field (static magnetic field) is present (ON) to a state in which the magnetic field is absent (OFF)

The demagnetization time is stored in the memory 204 as a design value of the MRI apparatus 100.
· Demagnetization completion time point: Time point at which the magnetic field (static magnetic field) becomes absent

The processor 202 can read the demagnetization time from the memory 204 and obtain the demagnetization completion time point by using the above-described [Equation 1].

In [Equation 1], in a case of the MRI apparatus that does not require the demagnetization standby time, the demagnetization completion time point can be obtained by setting the demagnetization standby time to zero.
· Post-demagnetization cooling time: Time taken from a temperature increase due to the demagnetization to a return to the normal temperature by cooling
· Post-demagnetization cooling completion time point: Time point at which the temperature returns to the normal temperature by cooling after the temperature increase due to the demagnetization

The post-demagnetization cooling time is stored in the memory 204 as a design value of the MRI apparatus 100.

The processor 202 reads the post-demagnetization cooling time from the memory 204 and obtains the post-demagnetization cooling completion time point by using the following calculation equation. [Equation 8] 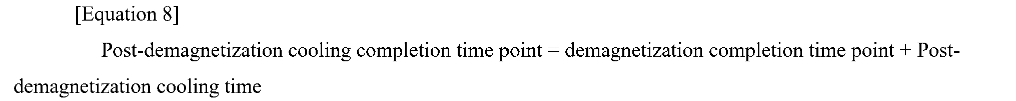 Post-demagnetization cooling completion time point = demagnetization completion time point + Post-demagnetization cooling time

Hereinafter, the definition of each time point and time in the excitation is the same as the above definition for demagnetization, with demagnetization replaced by excitation.
· Excitation start time point: Time point at which the user issues an instruction to perform the excitation by using an excitation start button or the like
· Excitation time: Time taken from a state in which the magnetic field (static magnetic field) is absent (OFF) to a state in which the magnetic field is present (ON)

The excitation time is stored in the memory 204 as a design value of the MRI apparatus 100.
· Post-excitation cooling time: Time taken from a temperature increase due to the excitation to a return to a normal temperature by cooling
· Post-excitation cooling completion time point: Time point at which the temperature returns to the normal temperature by cooling after the temperature increases due to the excitation

The post-excitation cooling time is stored in the memory 204 as a design value of the MRI apparatus 100, or is obtained from the information on the temperature change stored in the memory 204.

The processor 202 can read the post-excitation cooling time from the memory 204, or can obtain the post-excitation cooling time based on the information on the temperature change stored in the memory 204, and can obtain the post-excitation cooling completion time point by using the above-described [Equation 3].

Next, a prediction method of the temperature change of the magnet 104 (superconducting coil) will be described.

In order to predict the temperature change of the magnet 104, the following information is stored in the memory 204.
· Increase in temperature due to demagnetization: An increase in temperature from the normal temperature during the demagnetization period.
· Increase in temperature due to excitation: An increase in temperature from the normal temperature during the excitation period
· Function f indicating a temperature change curve in a case of cooling from the critical temperature Tc, or a table indicating a temperature change curve

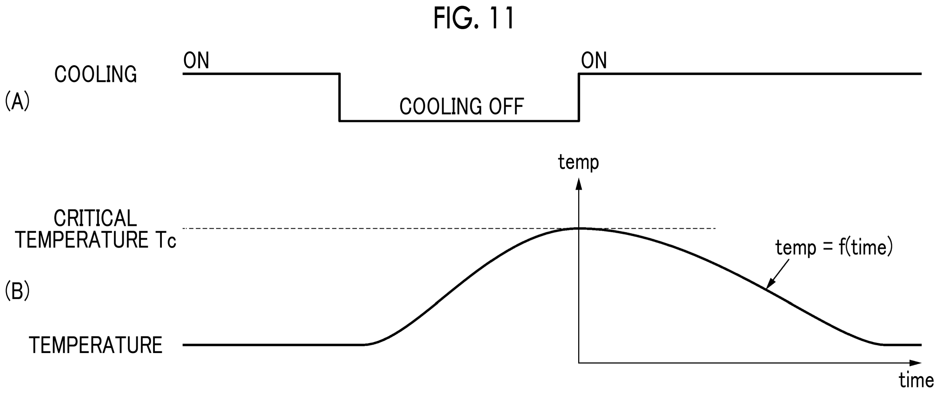

FIG. 11 is a diagram showing an example of a temperature change curve in a case of cooling from the critical temperature Tc, and as shown in (B) of FIG. 11, the temperature change curve is indicated by a function f(time) indicating a temperature (temp) with time as a parameter.

The function f can be acquired by turning off the coil cooling device at the time of design as shown in (A) of FIG. 11, increasing the temperature of the magnet 104 to the critical temperature Tc, turning on the coil cooling device again, and then measuring the temperature change of the magnet 104.

FIG. 12 is a diagram showing a function Δf(temp0, Δtime) that gives a temperature change after a time Δtime has elapsed from an initial temperature temp0.

The definition of Δf(temp0, Δtime) can be represented by the following expression. [Equation 9] $Δf \left(temp0,Δtime\right) = f \left(time0+Δtime\right) - temp 0$

Here, time0 is a value that satisfies temp0 = f(time0).

Since the function f monotonically decreases as shown in FIG. 11, time0 is uniquely determined and can be expressed as time0 = f⁻¹(temp0).

As described above, the temperature changes due to demagnetization, excitation, and cooling by the coil cooling device can all be obtained.

### Temperature Immediately After Excitation Is Completed

For example, the temperature immediately after the excitation is completed can be obtained as follows. [Equation 10] 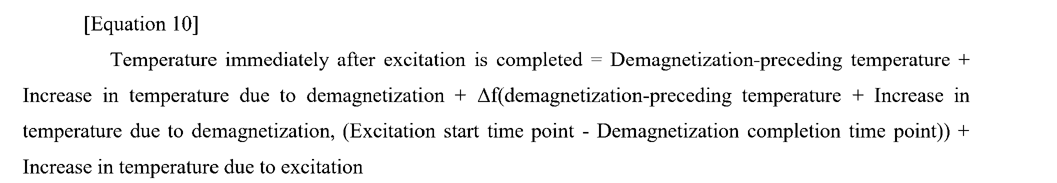 Temperature immediately after excitation is completed = Demagnetization-preceding temperature + Increase in temperature due to demagnetization + Δf(demagnetization-preceding temperature + Increase in temperature due to demagnetization, (Excitation start time point - Demagnetization completion time point)) + Increase in temperature due to excitation

### Temperature Change In Case of Excitation Without Sufficient Cooling After Demagnetization

The temperature of the superconducting coil in a case where excitation is performed without sufficient cooling after demagnetization changes as shown in (C) of FIG. 7.

The cooling time after excitation can be obtained by the following equation. [Equation 11] 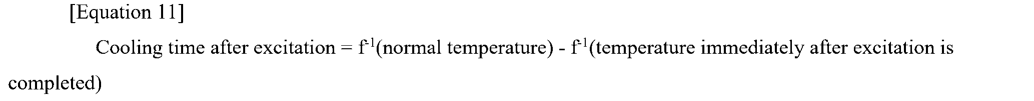 Cooling time after excitation = f-1(normal temperature) - f-1(temperature immediately after excitation is completed)

### Rationale for Requiring Temperature at Time of Excitation Completion and Time of Cooling Completion

As shown in FIG. 8, the display field 252 of the operation screen 250-2 displays the excitation completion time point and the predicted temperature at the excitation completion time point, and the display field 253 displays the cooling completion time point and the predicted temperature at the cooling completion time point.

The reason why the temperature at the time of excitation completion and the temperature at the time of cooling completion are required is that the hospital staff wants to confirm whether the examination (imaging) of the subject can be started without any problem after several hours and to eliminate the anxiety. The confirmation of the recovery of the magnetic field (the completion of the excitation or the completion of the cooling to the normal temperature) can be determined based on whether the temperature of the magnet 104 is in the low temperature state, and thus is displayed on the operation screen 250-2.

### Third Embodiment

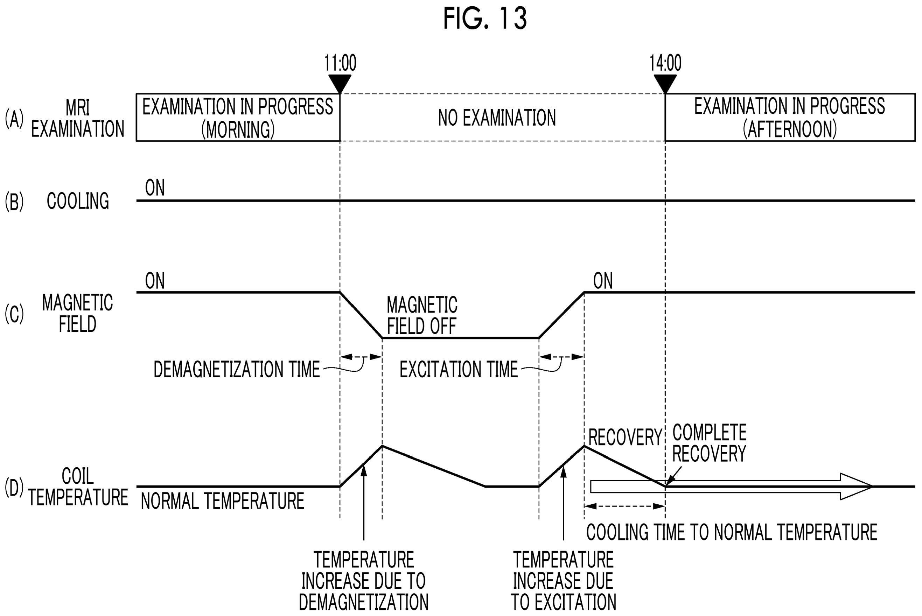

FIG. 13 is a timing chart showing the state of each part of the MRI apparatus according to the third embodiment of the magnetic resonance imaging system according to the present invention.

(A) to (D) of FIG. 13 correspond to the timing charts of the second embodiment shown in (A) to (D) of FIG. 9, respectively, and thus the detailed description thereof will be omitted.

The third embodiment is an embodiment in which the demagnetization and the excitation are controlled in a case in which an examination interval (for example, a free time of 2.5 hours or more) occurs.

In some hospitals, a free time of several hours may occur in a day of examination.

Since it is safer to have no magnetic field in the examination room (shielding room) in which the MRI apparatus 100 is installed, the hospital staff wants to turn off the magnetic field.

Therefore, after the demagnetization is started, the time until the recovery is displayed, and it is possible to determine whether the examination schedule is affected even in a case in which the demagnetization is performed.

In the example shown in (A) of FIG. 13, the free time of the examination is from 11:00 to 14:00.

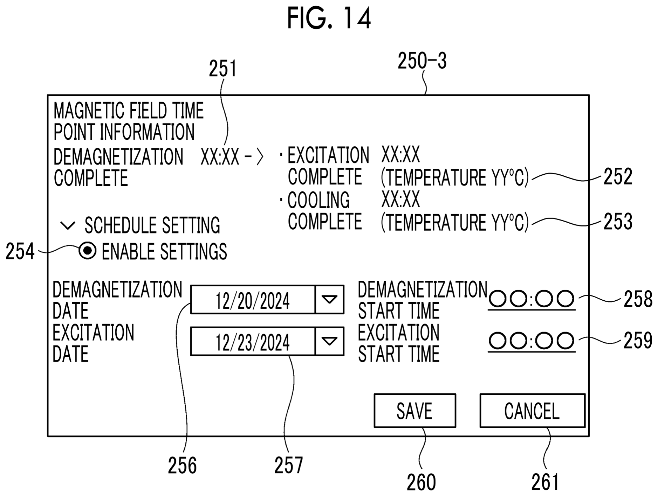

FIG. 14 is a diagram showing a third embodiment of the magnetic resonance imaging system according to the present invention, and particularly, is a diagram showing an operation screen of a display.

As shown in FIG. 14, the operator 220 inputs the demagnetization start time (time point) to an input field 258 of an operation screen 250-3, and inputs the excitation start time (time point) to an input field 259.

Here, the demagnetization start time point input to the input field 258 is the start time point of the free time of the examination, and the processor 202 calculates the demagnetization completion time point based on the demagnetization start time point and the demagnetization time as shown in [Equation 1], and displays the demagnetization completion time point in a display field 251. As a result, the operator 220 can ascertain the demagnetization completion time point. In a case in which the user operation start time point for instructing the demagnetization by the demagnetization start button or the like is input, the processor 202 can calculate the demagnetization completion time point by [Equation 1].

In addition, the excitation completion time point and the cooling completion time point calculated based on the excitation start time point input to the input field 259 are displayed in the display fields 252 and 253, respectively. As a result, the operator 220 can ascertain the end time of the free time of the examination (recovery time at which the examination can be performed).

According to the third embodiment, since the operator 220 can control the power supply of the magnet 104 (the superconducting coil) on the operation screen 250-3 while taking the recovery time point into consideration, the magnetic field can be controlled only by hospital staff even for several hours.

### Fourth Embodiment

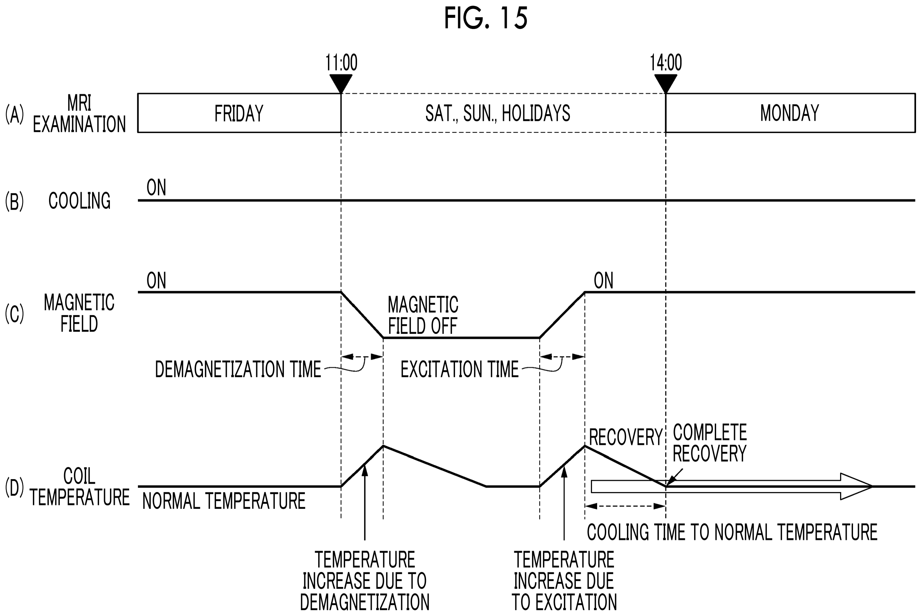

FIG. 15 is a timing chart showing the state of each part of the MRI apparatus according to the fourth embodiment of the magnetic resonance imaging system according to the present invention.

Since (A) to (D) of FIG. 15 correspond to the timing charts of the second embodiment shown in (A) to (D) of FIG. 9, respectively, the detailed description thereof will be omitted.

The fourth embodiment is an embodiment in which the demagnetization and the excitation are controlled in conjunction with a medical care holiday in a hospital.

In some hospitals, the medical care using the MRI apparatus 100 is completely stopped on holidays and national holidays. Further, since it is safer to have no magnetic field in the shielding room in which the MRI apparatus 100 is installed, the hospital staff wants to turn off the magnetic field.

In the example shown in (A) of FIG. 15, the schedule is set such that examination using the MRI apparatus 100 is stopped during a period from 11:00 on Saturday to 14:00 three days later (after the holiday).

That is, the operator 220 turns on the radio button 254 of the operation screen 250-3 shown in FIG. 14, enables the setting of the excitation start date and time and the demagnetization start date and time, and sets the demagnetization start date and the excitation start date in the list boxes 256 and 257. In addition, as described above, the input of the demagnetization start time point and the excitation start time point can also be performed by the input fields 258 and 259.

Here, the demagnetization start date and time is set by the demagnetization start date set in the list box 256 and the demagnetization start time point input to the input field 258. The demagnetization completion time point calculated based on the demagnetization start time point is displayed in the display field 251. As a result, the operator 220 can ascertain the demagnetization start date and the demagnetization completion time point.

In addition, the excitation start date and time is set by the excitation start date set in the list box 257 and the excitation start time point input to the input field 259. The excitation completion time point and the cooling completion time point calculated based on the excitation start time point are displayed in the display fields 252 and 253. As a result, the operator 220 can ascertain the excitation start date, the excitation completion time point, and the cooling completion time point.

According to the fourth embodiment, it is possible to complete the excitation even during a period in which the operator 220 is absent, such as a holiday, and to use the MRI apparatus 100 immediately on a subsequent weekday.

### Time Control and Check Function of Calculation Equation

The processor 202 has a function of checking whether the time control of the demagnetization/excitation is in contradiction with the calculation equation.

The time (each time shown in FIG. 10) related to the demagnetization and the excitation by the MRI apparatus 100 comprising the reduced-helium coil cooling device is, for example, as follows.
(1) Demagnetization standby time: 30 minutes
(2) Demagnetization time: 60 minutes
(3) Excitation time: 60 minutes
(4) Time to return to normal temperature: 120 minutes

These times are held in a memory as design values for each model of the MRI apparatus (for example, E.Smart, E.Synergy).

The magnet 104 (superconducting coil 230) is constantly kept cold (only the compressor that has been operating with the main power supply is switched to a backup power supply), and, in a case where demagnetization/excitation is subjected to time control through schedule setting, demagnetization is performed for one day or longer, therefore, in principle, such time control of demagnetization/excitation does not contradict with the calculation equation. The start time of the excitation is designated by the operator.

On the other hand, in a case in which the operator 220 tries to set the demagnetization/excitation in a time shorter than 2.5 hours, the time does not fall within the time of (1) to (3) (or (1) to (4)), and thus fails the calculation.

The processor 202 checks whether there is no contradiction between the demagnetization start time point and the excitation start time point (that is, the following is true).

A. Excitation completion time point - User operation start time point > Demagnetization standby time (1) + Demagnetization time (2) + Excitation time (3)

As shown in FIG. 10, the processor 202 determines whether the total time of (1) to (3) described above falls within the time from the user operation start time point to the excitation completion time point.

The time (4) for returning to the normal temperature after the excitation is not essential for the contradiction determination, but the time (4) may be further added to notify that the MRI apparatus 100 is in the stable state, and the contradiction determination may be performed in consideration of the total time of (1) to (4).

In addition, in a case of the MRI apparatus in which the demagnetization standby time from the instruction to start the demagnetization of the magnet to the start of the demagnetization of the magnet is not necessary, the demagnetization standby time (1) is naturally zero.

In a case in which the demagnetization start instruction is received, the processor 202 acquires the operable time point at which the MRI apparatus 100 can start to operate next after the demagnetization of the magnet 104 is started, based on the received demagnetization start time point and the design value of the MRI apparatus 100. The demagnetization completion time point can be calculated from [Equation 1]. In a case in which the demagnetization completion time point is calculated, the excitation completion time point can be calculated from the demagnetization completion time point by [Equation 2] or [Equation 2']. In a case in which the excitation completion time point is further calculated, the post-excitation cooling completion time point can be calculated by [Equation 3].

Therefore, the processor 202 can calculate the operable time point (the excitation completion time point or the post-excitation cooling completion time point) at which the MRI apparatus 100 can be reactivated based on the demagnetization start time point and the design values (the standby time, the demagnetization time, the excitation time, the pre-excitation waiting time, the post-excitation cooling time, and the like) of the MRI apparatus 100.

The above-described calculation equations can be stored in the memory 204, and each design value of the MRI apparatus 100 can be stored together with the calculation equation as a constant of each calculation equation. In addition, instead of each calculation equation, a table corresponding to each calculation equation may be stored in the memory 204. The processor 202 can read out a necessary calculation equation or table from the memory 204 and acquire the operable time point or the like by using the calculation equation or the table.

In addition, in a case in which the user-set operation start time point of the MRI apparatus 100 is a time point earlier than the operable time point, the processor 202 can determine that the user-set operation start time point is in contradiction with the operable time point.

In a case in which the processor 202 determines that the user-set operation start time point is in contradiction with the operable time point, it is preferable that the processor 202 issues a notification of a warning indicating the contradiction by using the operation screen or the like of the display 208 or issues an instruction to correct the schedule such as the user-set operation start time point by using the operation screen or the like of the display 208.

B. The processor 202 checks whether the predicted temperature immediately after the excitation is completed is equal to or lower than the critical temperature Tc.

The temperature immediately after the excitation is completed can be obtained by [Equation 10] described above.

In a case in which the temperature immediately after the excitation is completed, which is obtained by [Equation 10], exceeds the critical temperature Tc, it is not appropriate to reactivate the MRI apparatus 100. The operator 220 can check the temperature immediately after the excitation is completed on the operation screen (the display field 252 of the operation screen 250-2 shown in FIG. 8) of the display 208. In a case in which the temperature immediately after the excitation is completed exceeds the critical temperature Tc, it is preferable that the processor 202 changes the temperature displayed in the display field 252 of the operation screen 250-2 to red text or the like and issues a warning to the operator 220.

### Fifth Embodiment

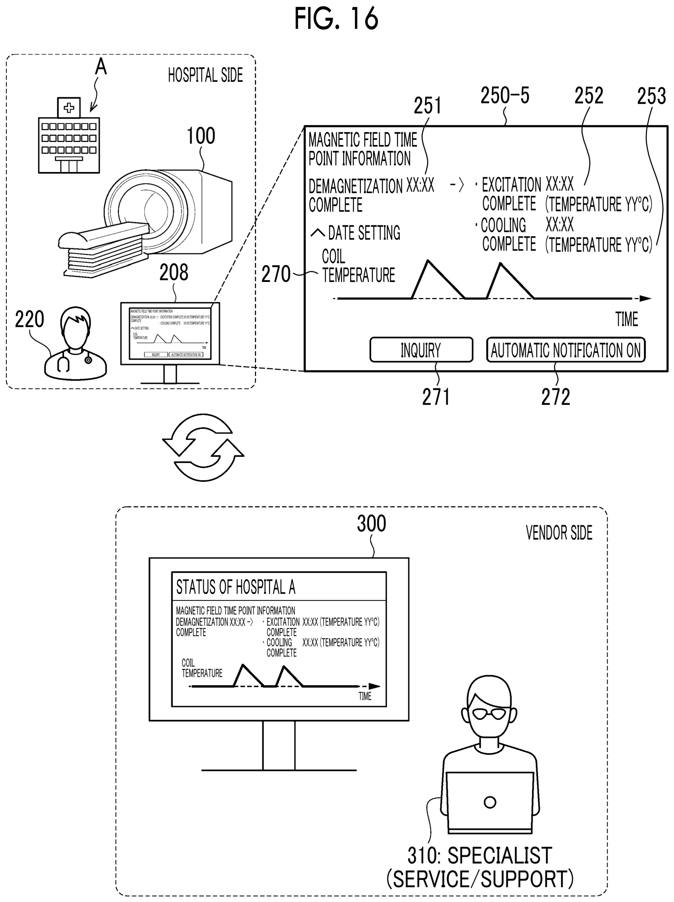

FIG. 16 is a schematic diagram showing a fifth embodiment of the magnetic resonance imaging system according to the embodiment of the present invention, and particularly shows a system that communicates between a hospital side and a vendor side and shares information and the like.

In FIG. 16, even in a case in which the power supply of the MRI apparatus 100 body is turned off for several days due to the circumstances of the hospital A such as a planned power outage or the like, the specialist 310 on the vendor side of the MRI apparatus 100 can remotely access the hospital A and easily check the recovery state of the MRI apparatus 100 as long as the time control of the demagnetization/excitation, the state of the magnetic field, and the temperature of the magnet 104 are visualized.

As shown in FIG. 14, in a case in which the demagnetization start time (time point) and the excitation start time (time point) are set by the user using the input fields 258 and 259 of the operation screen 250-3 of the display 208, the demagnetization completion time point, the excitation completion time point, and the cooling completion time point are calculated and displayed in the display fields 251, 252, and 253 of the operation screen 250-3, respectively. However, in the fifth embodiment, on the operation screen 250-5 of the display 208 shown in FIG. 16, the demagnetization completion time point, the excitation completion time point, and the cooling completion time point are displayed in the display fields 251, 252, and 253 of the operation screen 250-5 in the same manner as the operation screen 250-3 shown in FIG. 14.

In addition, the operation screen 250-5 shown in FIG. 16 includes a coil temperature display unit 270, and the processor 202 displays the temperature of the superconducting coil (magnet 104) on a moment-by-moment basis on the coil temperature display unit 270.

That is, the MRI apparatus 100 includes a temperature sensor 238 (see FIG. 3) that detects the temperature of the magnet 104 or the superconducting coil 230, and the processor 202 displays the temperature at each time point detected by the temperature sensor 238 on the coil temperature display unit 270 of the operation screen 250-5. The coil temperature display unit 270 displays a graph showing the coil temperature with the horizontal axis as a time axis. It is preferable that the critical temperature Tc is also displayed on the graph. In addition, since the coil temperature can be predicted, the coil temperature display unit 270 may display the predicted coil temperature in addition to the monitored coil temperature.

In the fifth embodiment, as shown in FIG. 16, the information such as the demagnetization completion time point, the excitation completion time point, the cooling completion time point, and the coil temperature displayed on the operation screen 250-5 on the hospital side is notified to the vendor side via the network, and the information indicating the status of the MRI apparatus 100 of the hospital A is displayed on the display 300 on the vendor side, so that the information can be shared between the hospital side and the vendor side.

According to the fifth embodiment, for example, even in a case where the operation of the MRI apparatus 100 is stopped for several days, the vendor side does not need to dispatch the specialist 310, so that the time and effort can be reduced.

### Notification Method to Vendor

### Inquiry

The operation screen 250-5 shown in FIG. 16 includes an inquiry button 271 for contacting the specialist 310 of the vendor, and in a case where the inquiry button 271 is operated (clicked) by the operator 220, the processor 202 enables the inquiry (telephone contact and/or automatic distribution of e-mails, and the like) with the specialist 310, and notifies the vendor of the information (information notified to the operator 220) displayed on the operation screen 250-5, and displays the information on the display 300 on the vendor side.

### Automatic Notification

The operation screen 250-5 shown in FIG. 16 includes an automatic notification ON button 272, and in a case where the operator 220 turns on the automatic notification ON button 272, the processor 202 notifies the vendor of the information displayed on the operation screen 250-5 in a case where a certain condition is satisfied, and displays the information on the display 300 on the vendor side.

Examples that the certain condition is satisfied include a case where the temperature of the superconducting coil 230 exceeds the temperature threshold value Th and/or a case where the temperature of the superconducting coil 230 falls below the temperature threshold value Th.

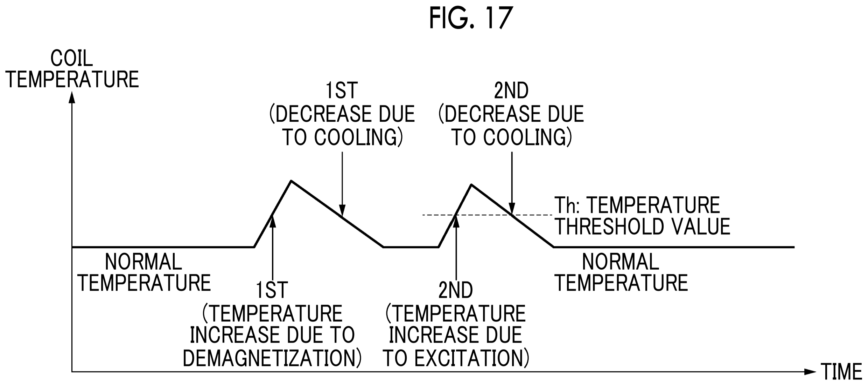

FIG. 17 is a graph showing an example of a change in the coil temperature due to the time control of the demagnetization/excitation.

As shown in FIG. 17, the temperature of the superconducting coil 230 cooled to the normal temperature is increased due to the demagnetization. This temperature increase is referred to as a first temperature increase.

Subsequently, after the temperature is increased due to the demagnetization, the temperature of the superconducting coil 230 is decreased due to the cooling by the coil cooling device. This temperature decrease is referred to as a first temperature decrease.

After the first temperature decrease, the temperature of the superconducting coil 230 is increased due to the excitation. This temperature increase is referred to as a second temperature increase.

Subsequently, after the temperature is increased due to the excitation, the temperature of the superconducting coil 230 is decreased due to the cooling by the coil cooling device. This temperature decrease is referred to as a second temperature decrease.

In a case where the automatic notification ON is set by the automatic notification ON button 272, in a case where the temperature exceeds the temperature threshold value Th due to the second temperature increase as shown in FIG. 17, the processor 202 notifies the vendor of the information displayed on the operation screen 250-5 at the timing at which the temperature exceeds the temperature threshold value Th, and displays the information on the display 300 on the vendor side.

In a case where the temperature exceeds the temperature threshold value Th due to the second temperature increase, the MRI apparatus 100 has already started a normal recovery operation, and it is preferable to notify the vendor at this timing.

In addition, in a case where the automatic notification ON is set, in a case where the temperature falls below the temperature threshold value Th due to the second temperature decrease as shown in FIG. 17, the processor 202 may notify the vendor of the information displayed on the operation screen 250-5 at the timing at which the temperature falls below the temperature threshold value Th, and display the information on the display 300 on the vendor side.

In a case where the temperature falls below the temperature threshold value Th due to the second temperature decrease, the MRI apparatus 100 is heading toward complete recovery, and it is preferable to notify the vendor at this timing.

As a certain condition, the setting of the automatic notification ON by the automatic notification ON button 272 is also one of the conditions, but a condition may be set to only a case where the temperature exceeds the temperature threshold value Th due to the second temperature increase or a case where the temperature falls below the temperature threshold value Th due to the second temperature decrease without providing the automatic notification ON button 272.

### Saving of Schedule

As shown in FIG. 14, the operation screen 250-3 of the display 208 includes a save button 260 for saving a schedule including the demagnetization start time point and the excitation start time point of the magnet 104 set by the user, and in a case where the operator 220 sets the schedule and the save button 260 is operated (clicked), the processor 202 saves the schedule set by the user in the memory 204, and notifies the vendor of the information (information notified to the operator 220) displayed on the operation screen 250-5 shown in FIG. 16, and displays the information on the display 300 on the vendor side.

As a result, the operator 220 can notify the vendor of the information displayed on the operation screen 250-3 automatically in conjunction with the operation of the save button 260 without being aware of the notification to the vendor.

The operation button for automatically notifying the vendor of the information displayed on the operation screen 250-3 is not limited to the automatic notification ON button 272 or the save button 260.

### Operation Method of Magnetic Resonance Imaging System

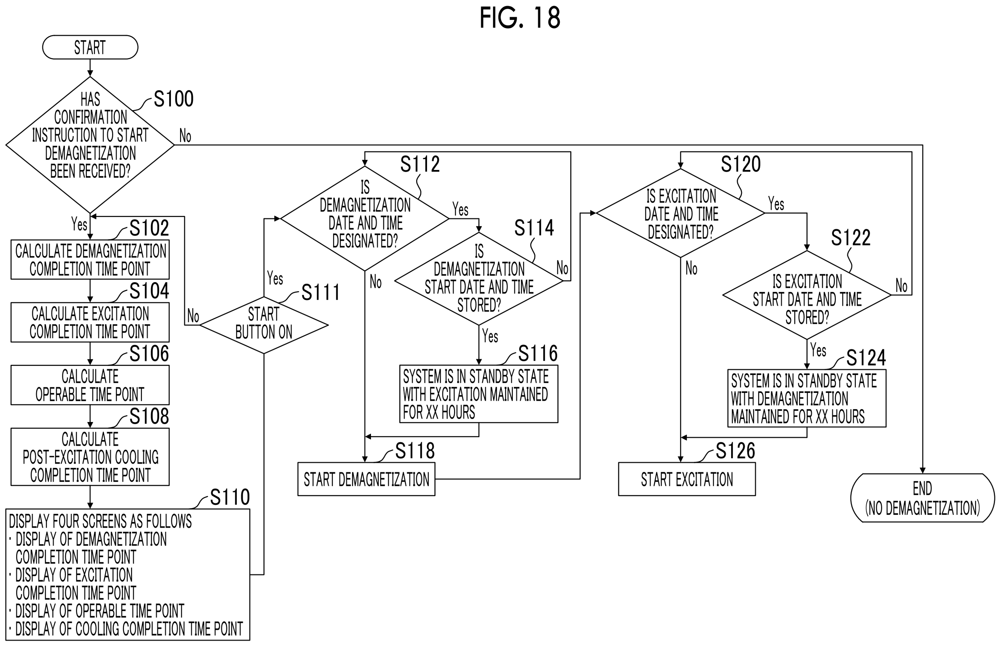

FIG. 18 is a flowchart showing an embodiment of an operation method of the magnetic resonance imaging system according to the embodiment of the present invention.

The processor 202 of the magnetic resonance imaging system 10 shown in FIG. 2 receives various instruction inputs from the operation unit 210 according to the flowchart shown in FIG. 18, and executes processing corresponding to the received instruction inputs.

In FIG. 18, the processor 202 determines whether a confirmation instruction to start demagnetization of the magnet 104 has been received via the user interface including the display 208, the operation unit 210, and the like (step S100). For example, in a case where an "OFF" button for demagnetization of the magnet 104 is operated on the operation screen of the display 208 shown in FIG. 4, the processor 202 receives the confirmation instruction to start demagnetization.

In a case where the confirmation instruction to start demagnetization is received (in a case of "Yes"), the processor 202 calculates a demagnetization completion time point at which demagnetization is completed in a case where demagnetization of the magnet 104 is started, an excitation completion time point at which excitation of the magnet 104 is completed next after demagnetization is completed, an operable time point at which the MRI apparatus 100 can be reactivated next after demagnetization is completed, and a cooling completion time point after excitation, respectively (steps S102 to S108).

Each of these time points can be calculated based on the current time point and the design value of the MRI apparatus 100 stored in the memory 204. In addition, in a case where the operable time point is the excitation completion time point or the post-excitation cooling completion time point, the calculation of the operable time point is not necessary, and in a case where the time point is a time point (for example, an intermediate time point) between the excitation completion time point and the post-excitation cooling completion time point, the time point can be set as the operable time point.

Subsequently, the processor 202 displays the four time points calculated in steps S102 to S108 on the operation screen (step S110). It should be noted that, although the excitation completion time point is displayed in the display field 246 of the operation screen 250-1 shown in FIG. 5, the four time points can be displayed as described above.

Next, the processor 202 determines whether the "START" button 244 for starting demagnetization is turned on (step S111). In a case where the "START" button 244 is not turned on (in a case of "No"), the processing returns to step S102, and the processing of steps S102 to S110 is repeatedly executed.

In a case where the "START" button 244 is turned on (in a case of "Yes"), the processing transitions to step S112, and here, the processor 202 determines whether the demagnetization date and time is designated. The demagnetization date and time can be designated on the operation screen 250-3 shown in FIG. 14.

In step S112, in a case where the processor 202 determines that the demagnetization date and time is designated (in a case of "Yes"), the processor 202 subsequently determines whether the demagnetization start date and time is stored (step S114). Whether the demagnetization start date and time is stored can be determined by whether the save button 260 (see FIG. 14) is turned on.

In step S114, in a case where the processor 202 determines that the demagnetization start date and time is not stored (in a case of "No"), the processing returns to step S112, and in a case where the processor 202 determines that the demagnetization start date and time is stored (in a case of "Yes"), the processing transitions to step S116.

In step S116, the processor 202 sets the system to the standby state while the magnet 104 is excited for a time until the demagnetization start date and time, and in a case where the demagnetization start date and time is reached, the processing transitions to step S118, and the demagnetization of the magnet 104 is started.

On the other hand, in step S112, in a case where the processor 202 determines that the demagnetization date and time is not designated (in a case of "No"), the processor 202 transitions to step S118, and the demagnetization of the magnet 104 is started.

In a case where the demagnetization of the magnet 104 is started, the processor 202 transitions to step S120, and determines whether the excitation date and time is designated. The excitation date and time can be designated on the operation screen 250-3 shown in FIG. 14.

In step S120, in a case where the processor 202 determines that the excitation date and time is designated (in a case of "Yes"), the processor 202 subsequently determines whether the excitation start date and time is stored (step S122). Whether the excitation start date and time is stored can be determined by whether the save button 260 (see FIG. 14) is turned on.

In step S122, in a case where the processor 202 determines that the excitation start date and time is not stored (in a case of "No"), the processing returns to step S120, and in a case where the processor 202 determines that the excitation start date and time is stored (in a case of "Yes"), the processing transitions to step S124.

In step S124, the processor 202 sets the system to the standby state while the magnet 104 is demagnetized for a time until the excitation start date and time, and in a case where the excitation start date and time is reached, the processing transitions to step S126, and the excitation processing of the magnet 104 is performed.

On the other hand, in step S120, in a case where the processor 202 determines that the excitation date and time is not designated (in a case of "No"), the processor 202 transitions to step S126, and the excitation processing of the magnet 104 is performed.

In the excitation processing, the excitation is started after the confirmation of the state in which the excitation can be performed, such as the confirmation that the demagnetization is completed or the confirmation that the actual temperature has decreased to the temperature at which the excitation can be performed, is completed and in a case where the excitation date and time is not designated, in the present example, the excitation is started immediately after the demagnetization completion in the MRI apparatus corresponding to the first pattern, and the excitation is started after the waiting for the pre-excitation waiting time after the demagnetization in the MRI apparatus corresponding to the second pattern.

### Others

In the present embodiment, each processing of the processor is executed by any computer. In addition, any computer may execute the processing by using a processor as hardware, a program as software, or a combination thereof. In that case, the processor is configured to execute various types of processes in the present embodiment in cooperation with the program and can function as each unit or each means in the present embodiment. Further, the execution order of the processes by the processor is not limited to the order described and may be changed as appropriate. Any computer may be a general purpose computer, a special purpose computer, a workstation, or other system capable of executing each process.

The processor may be configured by one or a plurality of pieces of hardware, and the type of the hardware is not limited. For example, the processor can be configured with a central processing unit (CPU), a micro processing unit (MPU), a programmable logic device such as a field programmable gate array (FPGA), a dedicated circuit for executing specific processing such as an application specific integrated circuit (ASIC), or hardware such as a graphic processing unit (GPU) or a neural processing unit (NPU). In addition, the type of the hardware may be a combination of different types of hardware. In a case where a plurality of pieces of hardware are configured to execute one or a plurality of types of processing of a processor, the plurality of pieces of hardware may be present in apparatuses physically separated from each other, or may be present in the same apparatus. In any embodiment, an order of each type of processing performed by the processor is not limited to the above order and may be appropriately changed. The hardware is configured by an electric circuit (circuitry) in which circuit elements such as semiconductor elements are combined.

Further, the program may be software such as firmware or microcode. In addition, the program may be, for example, a program module group, and each function thereof may be realized by a processor configured to execute each function. The program may be a program code or a plurality of code segments stored in one or a plurality of non-transitory computer-readable media (for example, a storage medium or other storage). The program may be divided and saved in a plurality of non-transitory computer-readable media present in apparatuses physically separated from each other. The program code or the code segment may represent any combination of a procedure, a function, a subprogram, a routine, a subroutine, a module, a software package, a class, an instruction, a data structure, or a program statement. The program code or the code segment may be connected to another code segment or a hardware circuit by transmitting and receiving information, data, an argument, a parameter, or memory contents.

Furthermore, it is needless to say that the present invention is not limited to the above-described embodiments and various modifications can be made without departing from the gist of the present invention. Explanation of References
10: magnetic resonance imaging system
100: MRI apparatus
102: subject
104: magnet
106: gradient magnetic field coil
107: cold head
108: transmit coil
110: receive coil
112: high-frequency magnetic field generator
114: gradient magnetic field power supply
116: receiver
118: sequencer
120: imaging space
130: patient table
130A: tabletop
200: control device
202: processor
204: memory
206: input/output interface
208, 300: display
210: operation unit
220: operator
230: superconducting coil
232: vacuum vessel
232a: outer vessel
232b: inner vessel
234: radiation heat shield plate
236: heat conduction member
238: temperature sensor
242, 246, 251, 252, 253: display field
244: "START" button
250-1, 250-2, 250-3, 250-5: operation screen
254: radio button
256, 257: list box
258, 259: input field
260: save button
270: coil temperature display unit
271: inquiry button
272: automatic notification ON button
310: specialist

## Claims

1. A magnetic resonance imaging system comprising:
a magnetic resonance imaging apparatus;
a processor; and
a user interface,
wherein the magnetic resonance imaging apparatus includes
a superconducting magnet including a superconducting coil that is cooled to a first temperature at which superconductivity is achieved, and
a coil cooling device that cools the superconducting coil by heat conduction due to contact between a heat conduction member that is cooled via a cold head and the superconducting coil to cool the superconducting coil to the first temperature,
the processor is configured to:
acquire an operable time point at which the magnetic resonance imaging apparatus is able to start operating after demagnetization of the superconducting magnet is started based on a demagnetization start time point at which the superconducting magnet is to be demagnetized and a design value of the magnetic resonance imaging apparatus; and
notify an operator of the operable time point via the user interface.

2. The magnetic resonance imaging system according to claim 1,
wherein the design value of the magnetic resonance imaging apparatus includes a demagnetization time from a start of the demagnetization of the superconducting magnet to completion of the demagnetization and an excitation time from a start of excitation of the superconducting magnet to completion of the excitation, and
the processor is configured to acquire the operable time point obtained by adding the demagnetization time and the excitation time to the demagnetization start time point.

3. The magnetic resonance imaging system according to claim 2,
wherein, in a case where demagnetization control corresponding to the demagnetization time and excitation control corresponding to the excitation time are consecutively performed and a temperature of the superconducting coil exceeds a second temperature higher than the first temperature,
the design value of the magnetic resonance imaging apparatus further includes a waiting time from the completion of the demagnetization of the superconducting magnet to the start of the excitation of the superconducting magnet, and
the processor is configured to acquire the operable time point obtained by adding the demagnetization time, the waiting time, and the excitation time to the demagnetization start time point.

4. The magnetic resonance imaging system according to any one of the preceding claims,
wherein the design value of the magnetic resonance imaging apparatus includes a demagnetization time from a start of the demagnetization of the superconducting magnet to completion of the demagnetization, an excitation time from a start of excitation of the superconducting magnet to completion of the excitation, and a post-excitation cooling time from the completion of the excitation of the superconducting magnet to recovery of a temperature of the superconducting coil to the first temperature, and
the processor is configured to acquire the operable time point obtained by adding the demagnetization time, the excitation time, and the post-excitation cooling time to the demagnetization start time point.

5. The magnetic resonance imaging system according to any one of the preceding claims ,
wherein the design value of the magnetic resonance imaging apparatus includes a demagnetization standby time from an instruction to start the demagnetization of the superconducting magnet by the operator to a start of the demagnetization of the superconducting magnet, a demagnetization time from a start of the demagnetization of the superconducting magnet to completion of the demagnetization, an excitation time from a start of excitation of the superconducting magnet to completion of the excitation, and a post-excitation cooling time from the completion of the excitation of the superconducting magnet to recovery of a temperature of the superconducting coil to the first temperature, and
the processor is configured to acquire the operable time point obtained by adding the demagnetization standby time, the demagnetization time, the excitation time, and the post-excitation cooling time to the demagnetization start time point.

6. The magnetic resonance imaging system according to any one of claims 1 to 5, wherein the processor is configured to:
acquire the demagnetization start time point and a demagnetization time from a start of the demagnetization of the superconducting magnet to completion of the demagnetization;
acquire a demagnetization completion time point obtained by adding the demagnetization time to the demagnetization start time point; and
notify the operator of the demagnetization completion time point via the user interface.

7. The magnetic resonance imaging system according to any one of claims 1 to 5, further comprising:
a memory that stores a calculation equation or a table including the design value of the magnetic resonance imaging apparatus,
wherein the processor is configured to acquire at least the operable time point by using the demagnetization start time point and the calculation equation or the table.

8. The magnetic resonance imaging system according to claim 7, wherein the processor is configured to:
predict a temperature of the superconducting coil in at least one of a case where an excitation of the superconducting magnet is completed or a case where cooling is completed after the excitation of the superconducting magnet; and
notify the operator of the predicted temperature via the user interface.

9. The magnetic resonance imaging system according to any one of claims 1 to 8, wherein the processor is configured to:
receive a schedule including the demagnetization start time point and an excitation start time point of the superconducting magnet, which are set by a user; and
notify the operator of the schedule via the user interface, and
preferably,
the schedule includes an operation start time point of the magnetic resonance imaging apparatus, and
the processor is configured to:
check whether the operation start time point is an earlier time point than the operable time point; and
in a case where the operation start time point is an earlier time point than the operable time point, notify, via the user interface, the operator of a warning that the operation start time point is contradictory, or instruct correction of the schedule.

10. The magnetic resonance imaging system according to any one of claims 1 to 9, further comprising:
a temperature sensor that detects a temperature of the superconducting magnet or the superconducting coil,
wherein the processor is configured to notify the operator of a temperature at each time point detected by the temperature sensor via the user interface.

11. The magnetic resonance imaging system according to any one of claims 1 to 10,
wherein the user interface includes an inquiry button for contacting a specialist of a vendor of the magnetic resonance imaging apparatus, and
the processor is configured to:
enable communication with the specialist in a case where the inquiry button is operated; and
notify the vendor of information notified to the operator via the user interface.

12. The magnetic resonance imaging system according to any one of claims 1 to 11,
wherein the user interface includes an operation button that enables automatic notification to a vendor of the magnetic resonance imaging apparatus, and
the processor is configured to notify the vendor of information notified to the operator via the user interface based on an operation of the operation button.

13. The magnetic resonance imaging system according to any one of claims 1 to 12,
wherein the processor is configured to notify a vendor of the magnetic resonance imaging apparatus of information notified to the operator via the user interface in at least one of a case where a temperature of the superconducting magnet is decreased by the coil cooling device after the demagnetization of the superconducting magnet is completed and then the temperature is increased by subsequent excitation to exceed a temperature threshold value, or a case where the excitation of the superconducting magnet is completed, the temperature of the superconducting magnet is decreased by the coil cooling device, and the temperature falls below the temperature threshold value.

14. The magnetic resonance imaging system according to claim 12,
wherein the operation button is an automatic notification ON button, and
the processor is configured to notify the vendor of the magnetic resonance imaging apparatus of information notified to the operator via the user interface in at least one of a case where the automatic notification ON button is turned ON and a temperature of the superconducting magnet is decreased by the coil cooling device after the demagnetization of the superconducting magnet is completed and then the temperature is increased by subsequent excitation to exceed a temperature threshold value, or a case where the automatic notification ON button is turned ON and the excitation of the superconducting magnet is completed, the temperature of the superconducting magnet is decreased by the coil cooling device, and the temperature falls below the temperature threshold value,
or,
wherein the operation button is a save button for saving a schedule including the demagnetization start time point and an excitation start time point of the superconducting magnet, which are set by a user, and
the user interface is configured to, in a case where the save button is operated, save the schedule in a memory and notify the vendor of the magnetic resonance imaging apparatus of information notified to the operator via the user interface.

15. An operation method of a magnetic resonance imaging system including a magnetic resonance imaging apparatus, a processor, and a user interface,
wherein the magnetic resonance imaging apparatus includes a superconducting magnet including a superconducting coil that is cooled to a first temperature at which superconductivity is achieved, and a coil cooling device that cools the superconducting coil by heat conduction due to contact between a heat conduction member that is cooled via a cold head and the superconducting coil to cool the superconducting coil to the first temperature,
the operation method comprising:
acquiring, by the processor, an operable time point at which the magnetic resonance imaging apparatus is able to start operating after demagnetization of the superconducting magnet is started based on a demagnetization start time point at which the superconducting magnet is to be demagnetized and a design value of the magnetic resonance imaging apparatus; and
notifying, by the processor, an operator of the operable time point via the user interface.
